# EUROPEAN PATENT SPECIFICATION

(11) **EP 4 400 906 B1**
(45) Date of publication and mention of the grant of the patent: **11.03.2026**
(21) Application number: 24150847.2
(22) Date of filing: 09.01.2024
(51) Int. Cl.: G02F 1/13357, G02F 1/1335, G09G 3/34

(54) **DISPLAY DEVICE**
ANZEIGEVORRICHTUNG
DISPOSITIF D'AFFICHAGE

(30) Priority: 11.01.2023 KR 20230003918; 10.05.2023 KR 20230060391
(43) Date of publication of application: 17.07.2024
(73) Proprietor: LG Electronics Inc., Yeongdeungpo-gu Seoul 07336 (KR)
(72) Inventor: JUNG, Moongu, 06772 Seoul (KR); JUNG, Yongmin, 06772 Seoul (KR); HA, Seungsu, 06772 Seoul (KR)
(74) Representative: Schornack, Oliver

(56) References cited:
- CN-U- 214 315 432
- US-A1- 2018 045 877
- US-A1- 2022 244 597
- US-A1- 2023 004 047
- US-B2- 8 305 516
- US-B2- 8 344 973

## Description

### BACKGROUND OF THE INVENTION

### Field of the invention

The present disclosure relates to a display device.

### Description of the Related Art

With the development of the information society, there have been growing demands for various types of display devices, and in order to meet these demands, various display devices, such as a liquid crystal display (LCD) device, a plasma display panel (PDP), an electroluminescent display (ELD), a vacuum fluorescent display (VFD), etc., have been studied and used recently.

Among these devices, the LCD panel includes a TFT substrate and a color substrate which are positioned opposite each other with a liquid crystal layer interposed therebetween, and displays an image by using light provided by a backlight unit.

Recently, the structure of a substrate, on which light sources such as LEDs are mounted, is being actively researched. Further, research is being actively conducted to improve the image quality of an image displayed by a display panel.

For instance, US 2022/0244597 A1 relates to a display apparatus and a backlight module with light bars having a plurality of light emitting devices in a row, wherein several light emitting devices located in the same column are connected in series to form a dimming region. US 8,305,516 B2 relates to a backlight unit including a plurality of LED PCBs, each formed in a bar type, wherein a plurality of the bar type PCBs are divided into groups. For example, four bar type PCBs can be fabricated in a form of four-pronged spears by connecting their ends via a cable connected to a connector, and to implement a local dimming with respect to the plurality of LEDs. US 2023/004047 A1 and CN 214315432 U provide further background information regarding LED PCBs.

### SUMMARY OF THE INVENTION

It is an object of the present invention to provide a display device with a backlight unit providing for a less complex and easier electrical installation.

Another objective of the present disclosure may be to provide a display device in which substrate manufacturing costs may be reduced.

Another objective of the present disclosure may be to provide a structure capable of improving local dimming performance to improve image quality.

Another objective of the present disclosure may be to provide a structure capable of minimizing lifting of a reflective sheet on a substrate caused by diodes on the substrate, to improve image quality.

Another objective of the present disclosure may be to provide a structure capable of reducing the number of cables connecting an LED driver and a plurality of substrates.

Another objective of the present disclosure may be to provide various examples of substrate shapes and arrangements.

This object is solved by the present invention as defined in the independent claim. Preferred embodiments can be derived from the dependent claims.

### BRIEF DESCRIPTION OF THE DRAWINGS

The above and other objects, features and advantages of the present disclosure will be more apparent from the following detailed description in conjunction with the accompanying drawings, in which:

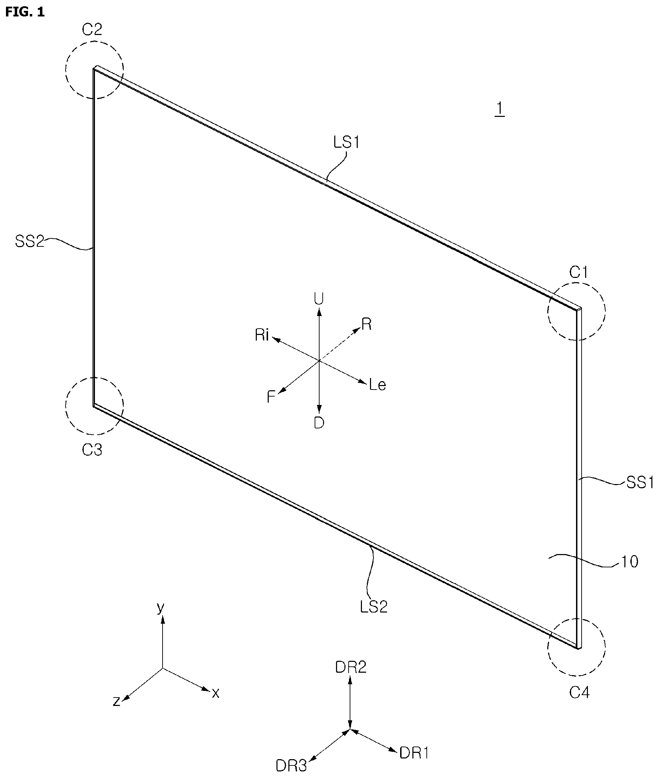

FIGS. 1 to 40 are diagrams illustrating examples of a display device according to embodiments of the present disclosure.

### DETAILED DESCRIPTION

Hereinafter, the present disclosure will be described in detail with reference to the accompanying drawings, in which the same reference numerals are used throughout the drawings to designate the same or similar components, and a redundant description thereof will be omitted.

The suffixes, such as "module" and "unit," for elements used in the following description are given simply in view of the ease of the description, and do not have a distinguishing meaning or role.

In addition, it will be noted that a detailed description of known arts will be omitted if it is determined that the detailed description of the known arts can obscure the embodiments of the present disclosure. Further, the accompanying drawings are used to help easily understand various technical features and it should be understood that the embodiments presented herein are not limited by the accompanying drawings.

It will be understood that although the terms first, second, etc. may be used herein to describe various elements, these elements should not be limited by these terms. These terms are only used to distinguish one element from another.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A singular representation may include a plural representation unless context clearly indicates otherwise.

It should be understood that the terms, "comprise," "include," "have," etc. when used in this specification, specify the presence of stated features, integers, steps, operations, elements, components, or combinations thereof but do not preclude the presence or addition of one or more other features, integers, steps, operations, elements, components, or combinations thereof.

References to directions, such as up (U), down (D), left (Le), right (Ri), front (F), and rear (R), shown in the drawings are provided merely for convenience of explanation and are not intended for limiting the scope of the present disclosure.

Referring to FIG. 1, a display device 1 may include a display panel 10. The display panel 10 may display an image.

The display device 1 may include a first long side LS1, a second long side LS2 opposite to the first long side LS1, a first short side SS1 adjacent to the first long side LS1 and the second long side LS2, and a second short side SS2 opposite to the first short side SS1. For convenience of explanation, it is illustrated and described that the first and second long sides LS1 and LS2 are longer than the first and second short sides SS1 and SS2, but it is also possible that lengths of the first and second long sides LS1 and LS2 may be approximately equal to lengths of the first and second short sides SS1 and SS2.

A direction parallel to the long sides LS1 and LS2 of the display device 1 may be referred to as a left-right direction or a first direction DR1. The first short side SS1 may be referred to as a left side Le, x, and the second short side SS2 may be referred to as a right side Ri.

A direction parallel to the short sides SS1 and SS2 of the display device 1 may be referred to as an up-down direction or a second direction DR2. The first long side LS1 may be referred to as an upper side U, y, and the second long side LS2 may be referred to as a lower side D.

A direction perpendicular to the long sides LS1 and LS2 and the short sides SS1 and SS2 of the display device 1 may be referred to as a front-rear direction or a third direction DR3. A side on which the display panel 10 displays an image may be referred to as a front side F, z, and a side opposite thereto may be referred to as a rear side R.

The first long side LS1, the second long side LS2, the first short side SS1, and the second short side SS2 may be referred to as edges of the display device 1. Further, positions where the first long side LS1, the second long side LS2, the first short side SS1, and the second short side SS2 meet each other may be referred to as corners. A position where the first short side SS1 and the first long side LS1 meet each other may be referred to as a first corner C1. A position where the first long side LS1 and the second short side SS2 meet each other may be referred to as a second corner C2. A position where the second short side SS2 and the second long side LS2 meet each other may be referred to as a third corner C3. A position where the second long side LS2 and the first short side SS1 meet each other may be referred to as a fourth corner C4.

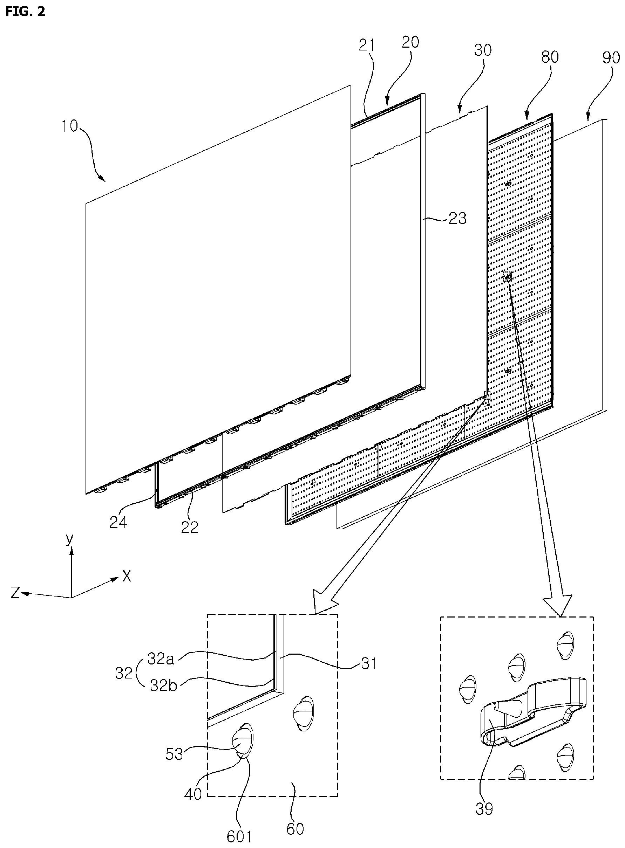

Referring to FIGS. 1 and 2, the display device 1 may include the display panel 10, a side frame 20, a backlight unit, a frame 80, and a back cover 90.

The display panel 10 may form a front surface of the display device 1 and may display an image. The display panel 10 may display an image in such a manner that a plurality of pixels output red, green, or blue (RGB) for each pixel according to the timing. The display panel 10 may be divided into an active area, in which the image is displayed, and a de-active area in which the image is not displayed. The display panel 10 may include a front substrate and a rear substrate which are opposite each other with a liquid crystal layer sandwiched between the two substrates. The display panel 10 may be referred to as an LCD panel 10.

The front substrate may include a plurality of pixels made up of red (R), green (G), and blue (B) subpixels. The front substrate may emit light corresponding to red, green, or blue color in response to a control signal.

The rear substrate may include switching elements. The rear substrate may switch on or off pixel electrodes. For example, the pixel electrode may change a molecular arrangement of a liquid crystal layer in response to a control signal received from the outside. The liquid crystal layer may include liquid crystal molecules. The arrangement of the liquid crystal molecules may be changed depending on a voltage difference between the pixel electrode and a common electrode. The liquid crystal layer may transmit light, provided from the backlight unit, to the front substrate or may block the light.

The side frame 20 may extend along the edges of the display panel 10. The side frame 20 may cover the edges of the display panel 10. For example, the side frame 20 may include a plastic or metal material. The side frame 20 may be referred to as a guide panel 20.

The backlight unit may be disposed at the rear of the display panel 10. The backlight unit may be disposed at the front of the frame 80 and may be coupled to the frame 80. The backlight unit may be driven by a full driving scheme or a partial driving scheme such as local dimming, impulsive driving, or the like. The backlight unit may include light sources providing light to the front, a substrate 40 on which the light sources are mounted, lenses 53 covering the light sources, a reflective sheet 60 covering a front surface of the substrate 40, and an optical unit 30 located at the front of the reflective sheet 60. Meanwhile, the front surface of the substrate 40 may also be coated with a reflective material.

The optical unit 30 may be opposite to the display panel 10 with respect to the side frame 20. The optical unit 30 may evenly transmit light from the light source to the display panel 10. The optical unit 30 may include a diffusion plate 31 and an optical sheet 32.

The diffusion plate 31 may be disposed between the reflective sheet 60 and the optical sheet 32. The diffusion plate 31 may diffuse light from the light source. Further, an air gap may be formed between the reflective sheet 60 and the diffusion plate 31. The air gap may serve as a buffer, and the light of the light source may be spread widely by the air gap. A supporter 39 may be disposed between the reflective sheet 60 and the diffusion plate 31, may be coupled to the reflective sheet 60, and may support the diffusion plate 31.

The optical sheet 32 may be adjacent to or in contact with a front surface of the diffusion plate 31. The optical sheet 32 may include at least one sheet. For example, the optical sheet 32 may include a plurality of sheets having different functions, and the plurality of sheets may be bonded or adhered to each other. For example, a first optical sheet 32a may be a diffusion sheet, and a second optical sheet 32b may be a prism sheet. The diffusion sheet may prevent light, emitted from the diffusion plate 31, from being partially concentrated, thereby providing uniform distribution of light. The prism sheet may collect light from the diffusion sheet and may provide the light to the display panel 10. The number and/or position of the diffusion sheet and the prism sheet may vary.

For example, the optical sheet 32 may change a wavelength or color of light provided from the light source. For example, the optical sheet 32 may include a red-based phosphor and/or a green-based phosphor. In this case, the light source may provide blue-based light, and the optical sheet 32 may convert the blue-based light to white light. The optical sheet 32 may be referred to as a Quantum Dot (QD) Sheet.

The frame 80 may be disposed at the rear of the backlight unit. The display panel 10, the side frame 20, and the backlight unit may be coupled to the frame 80. The frame 80 may support the above components of the display device as well as components which will be described later. For example, the frame 80 may be made of a metal material such as an aluminum alloy and the like. The frame 80 may be referred to as a main frame 80, a module cover 80, or a cover bottom 80.

The back cover 90 may cover the rear of the frame 80 and may be coupled to the frame 80. For example, the back cover 90 may be an injection-molded product of a resin material. In another example, the back cover 90 may be made of a metal material.

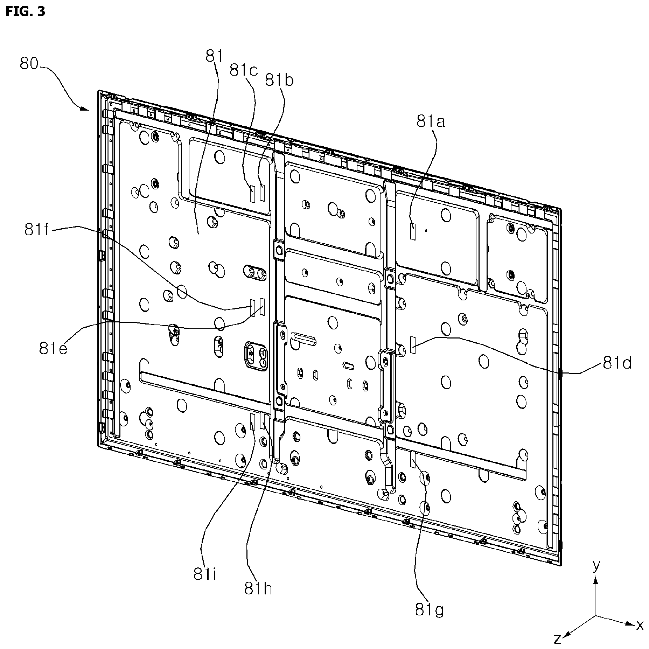

Referring to FIG. 3, a flat plate part 81 may define the front surface of the frame 80. A plurality of frame holes 81a, 81b, 81c, 81d, 81e, 81f, 81g, 81h, and 81i may be formed in the flat plate part 81.

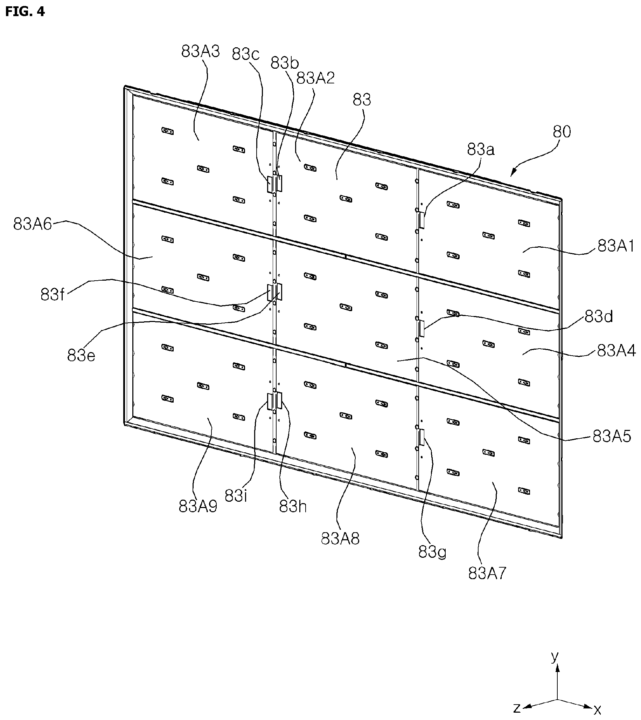

Referring to FIGS. 3 and 4, a heat sink 83 may cover a front surface of the flat plate part 81 and may be coupled to the flat plate part 81. A plurality of heat sink holes 83a, 83b, 83c, 83d, 83e, 83f, 83g, 83h, and 83i may be formed in the heat sink 83 and may be aligned with the plurality of frame holes 81a, 81b, 81c, 81d, 81e, 81f, 81g, 81h, and 81i. The heat skin 83 may be omitted.

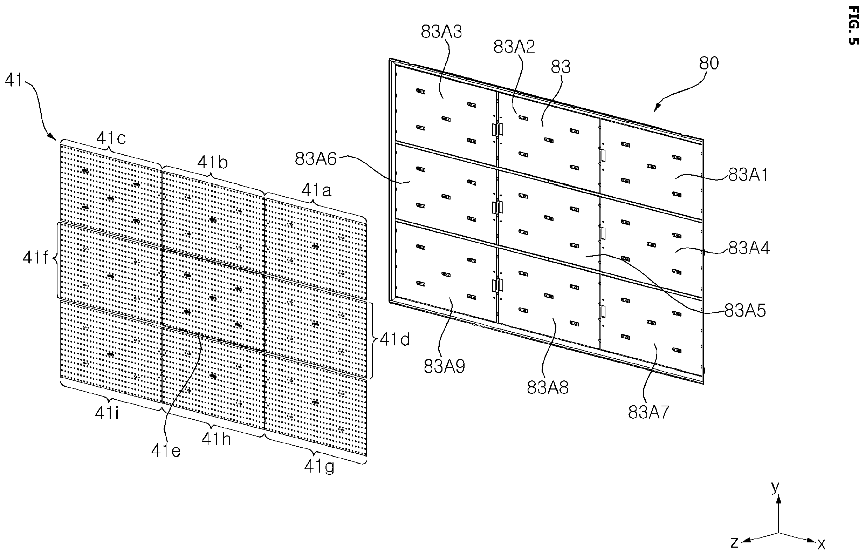

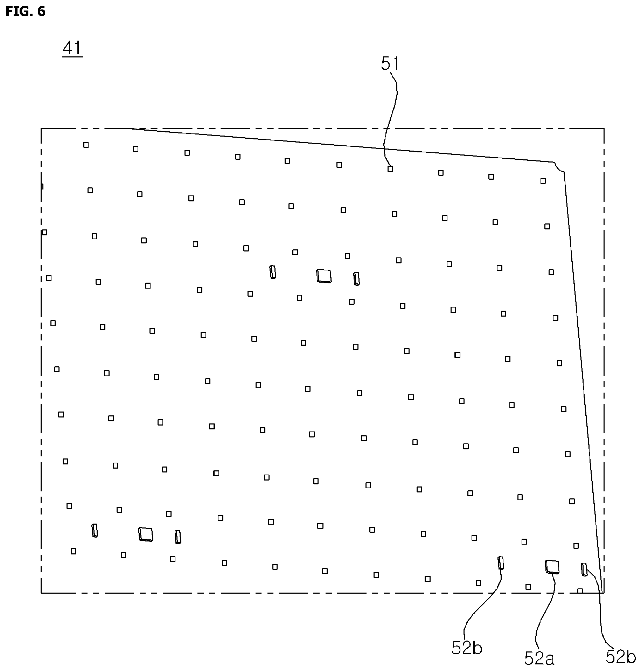

Referring to FIGS. 5 and 6, a substrate 41 may be coupled to the frame 80 or a front surface of the heat sink 83. The substrate 41 may be a printed circuit board (PCB). For example, the substrate 41 may be made of at least one of polyethylene terephthalate (PET), glass, polycarbonate (PC), and silicon. The substrate 41 may have a plate shape.

At least one substrate 41 may be provided. Each of a plurality of substrates 41a, 41b, 41c, 41d, 41e, 41f, 41g, 41h, and 41i may cover each of a plurality of regions 83A1, 83A2, 83A3, 83A4, 83A5, 83A6, 83A7, 83A8, and 83A9 of the heat sink 83.

A light source 51 may be mounted on a front surface of the substrate 41. A plurality of light sources 51 may be arranged in a matrix on the front surface of the substrate 41. The light source 51 may be a light emitting diode (LED) chip or an LED package. The light source 51 may be configured as a white LED or a colored LED emitting light of at least one of red, green, and blue colors, and the like. The light source 51 may be a mini-LED. An electrode pattern may be formed on the substrate 41 and may connect an adapter (connector) and the light source 51. A power supply board may provide power to the light source 51 through the substrate 41. For example, the electrode pattern may be a carbon nano tube (CNT) electrode pattern.

An integrated device 52a and a capacitor 52b may be disposed around the light source 51 and may be mounted on a front surface of the substrate 41. The integrated device 52a may be an IC chip. A plurality of capacitors 52b may be opposite to each other with respect to the integrated device 52a. The integrated device 52a may control power provided to a predetermined number of light sources 51.

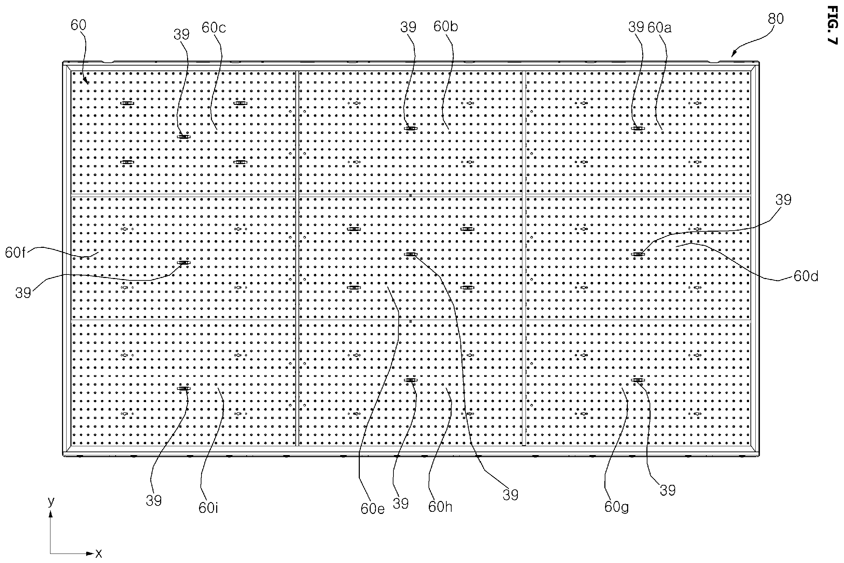

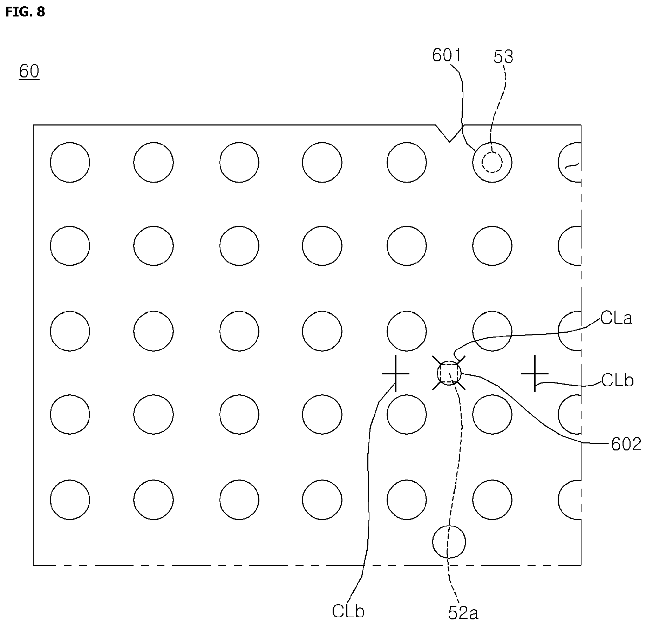

Referring to FIGS. 7 and 8, the reflective sheet 60 may be bonded to a front surface of the substrate 41 (see FIG. 5). The reflective sheet 60 may reflect light forward, which is provided from the light source 51 or reflected from the diffusion plate 31 (see FIG. 2). For example, the reflective sheet 60 may include a metal and/or metal oxide having high reflectance, such as at least one of aluminum (Al), silver (Ag), gold (Au), and titanium dioxide (TiO2). For example, the resin may be deposited or applied on the reflective sheet 60. There may be at least one reflective sheet 60. A plurality of reflective sheets 60a, 60b, 60c, 60d, 60e, 60f, 60g, 60h, and 60i may cover the substrate(s) 41 (see FIG. 5).

Holes 601 may be formed in the reflective sheet 60, and the light sources 51 (see FIG. 6) or the lenses 53 covering the light sources 51 may be disposed in the holes 601. A diameter of the hole 601 may be greater than a diameter of the lens 53. The number of holes 601 may be equal to the number of light sources 51 or the lenses 53.

A receiving hole 602 may be formed in the reflective sheet 60, and the integrated device 52a (see FIG. 6) may be disposed in the receiving hole 602. A first cut-line CLa formed around the receiving hole 602 may be opened by the integrated device 52a. Second cut-lines CLb in a cross shape may be formed in the reflective sheet 60 and may be opposite to each other with respect to the first cut-line CLa. The capacitors 52b (see FIG. 6) may be disposed on the second cut-lines CLb, and the second cut-lines CLb may be opened by the capacitors 52b. Accordingly, the reflective sheet 60 may be adhered to the substrate 41, and light uniformity may be improved.

Meanwhile, the supporter 39 may pass through the reflective sheet 60 and the substrate 41, to be removably coupled to the heat sink 83 and/or the frame 80. A plurality of supporters 39, which are spaced apart from each other, may be disposed on the reflective sheet 60. A front end of the supporter 39 may support the rear surface of the diffusion plate 31 (see FIG. 2).

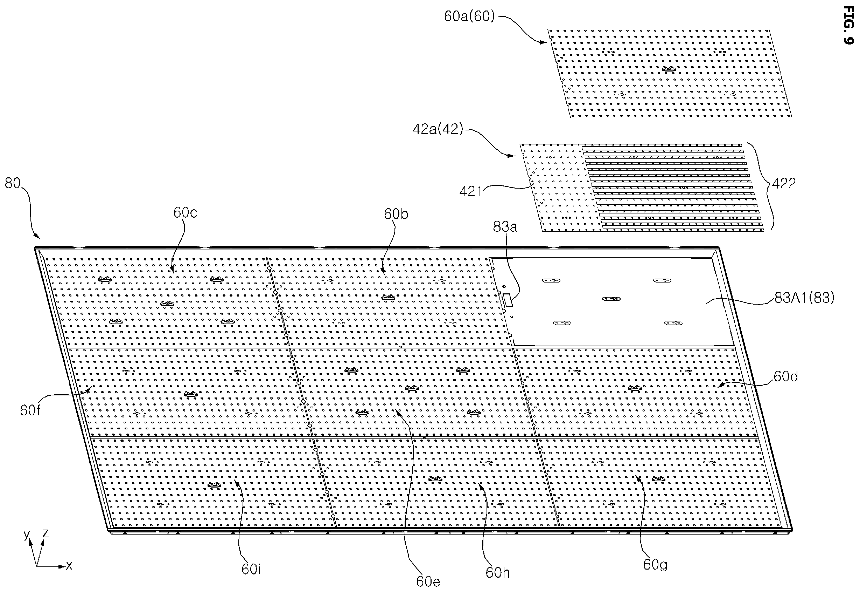

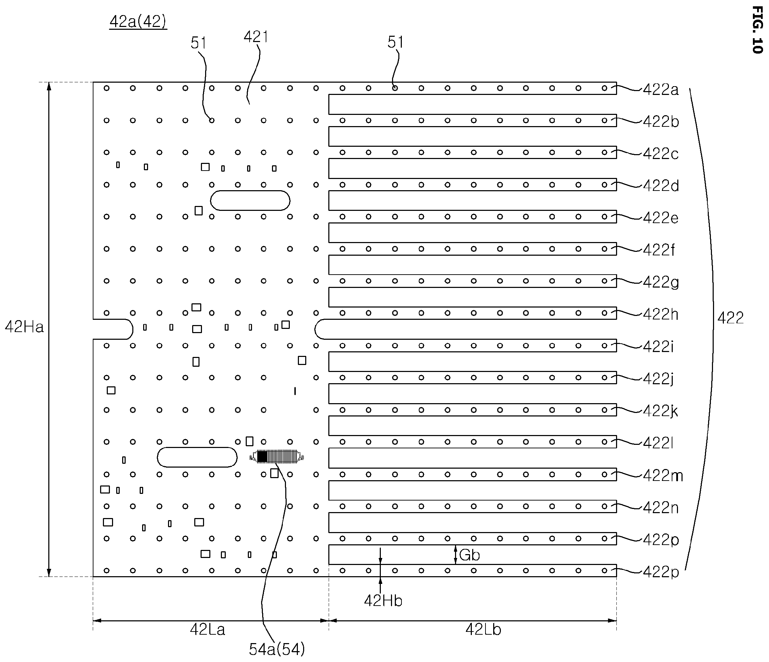

Referring to FIGS. 9 and 10, a substrate 42 may be coupled to the frame 80 or the front surface of the heat sink 83. The substrate 42 may be a printed circuit board (PCB). For example, the substrate 42 may be made of at least one of polyethylene terephthalate (PET), glass, polycarbonate (PC), and silicon. The substrate 42 may have a fork shape.

The substrate 42 may include a body 421 and legs 422. The body 421 may be elongated. The legs 422 may extend from one long side of the body 421 in a direction intersecting the body 421. A longitudinal direction of the body 421 may be defined in a vertical direction, and a longitudinal direction of the legs 422 may be defined in a horizontal direction. A width 42La of the body 421 may be smaller than a length 42Ha of the body 421 and may be smaller than or similar to a length 42Lb of the legs 422. The legs 422 may be spaced apart from each other in the longitudinal direction of the body 421. A gap Gb between the legs 422 may be equal to a width 42Hb of the legs 422.

There may be at least one substrate 42. Each of a plurality of substrates 42 may cover each of a plurality of regions 83A1, 83A2, 83A3, 83A4, 83A5, 83A6, 83A7, 83A8, and 83A9 (see FIG. 4) of the heat sink 83.

The light source 51 may be mounted on a front surface of the substrate 42. The plurality of light sources 51 may be arranged in a matrix on a front surface of the body 421 and the legs 422. The integrated device and the capacitor may be arranged around the light source 51 and may be mounted on the front surface of the substrate 42. The reflective sheet 60 may be bonded to the front surface of the substrate 42 and may have holes in which the light sources 51 or the lenses covering the light sources 51 are disposed. The plurality of reflective sheets 60a, 60b, 60c, 60d, 60e, 60f, 60g, 60h, and 60i may cover the substrate(s) 42.

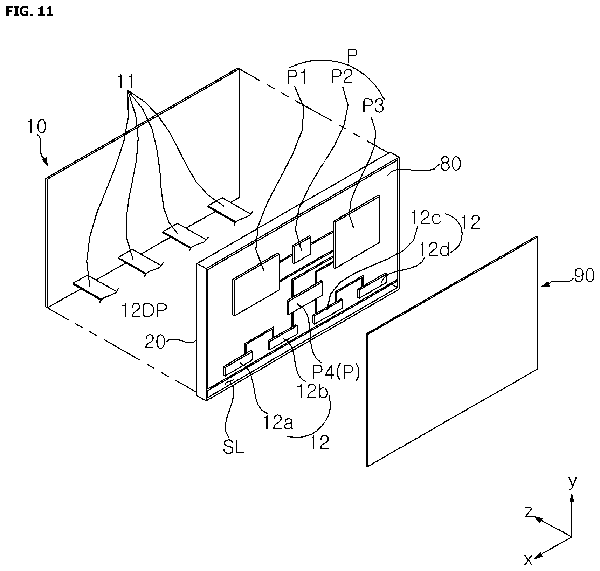

Referring to FIG. 11, a board P may be mounted on the frame 80. A plurality of electronic elements may be mounted on the board P. The board P may be a printed circuit board (PCB) and may be electrically connected to electronic parts of the display device. A plurality of boards P may be coupled to a rear surface of the frame 80.

A power supply board P1 may supply power to the respective components of the display device. A Light Emitting Diode (LED) driver P2 may be electrically connected to the power supply board P1 and a main board P3 through a cable and may supply power and current to the substrate on which light sources, such as LEDs, are mounted. The main board P3 may control the respective components of the display device. A timing controller board P4 may be connected to the main board P3 through a cable and may provide an image signal to the display panel 10. For example, the power supply board P1 may be adjacent to the left side of the frame 80, and the main board P3 may be adjacent to the right side of the frame 80. The LED driver P2 may be disposed between the power supply board P1 and the main board P3, and the timing controller board P4 may be disposed under the LED driver P2.

A cable 11 may be adjacent to the lower side of the display panel 10 and may be electrically connected to the display panel 10. The cable 11 may pass through a slit SL or hole formed in the frame 80. For example, the cable 11 may be a Chip On Film (COF).

A source Printed Circuit Board (PCB) 12 may be adjacent to the lower side of the frame 80 and coupled to the rear surface of the frame 80, and may be electrically connected to the cable 11. For example, a plurality of source PCBs 12a, 12b, 12c, and 12d may be spaced apart from each other along the lower side of the frame 80 and may be electrically connected to a plurality of cables 11. A second source PCB 12b may be electrically connected to a first source PCB 12a through a first bridge cable (not numbered). A third source PCB 12c may be electrically connected to a fourth source PCB 12d through a second bridge cable (not numbered). The second source PCB 12b and the third source PCB 12c may be electrically connected to the timing controller board P4 through connecting cables (not numbered). For example, the first and second bridge cables and the connecting cables may be Flexible Flat Cables (FFC).

Accordingly, the timing controller board P4 may provide digital video data and timing control signals to the display panel 10 through the source PCB 12.

The back cover 90 may be disposed at the rear of the frame 80 and may be coupled to the frame 80. The board P may be disposed between the frame 80 and the back cover 90 and may be covered by the back cover 90.

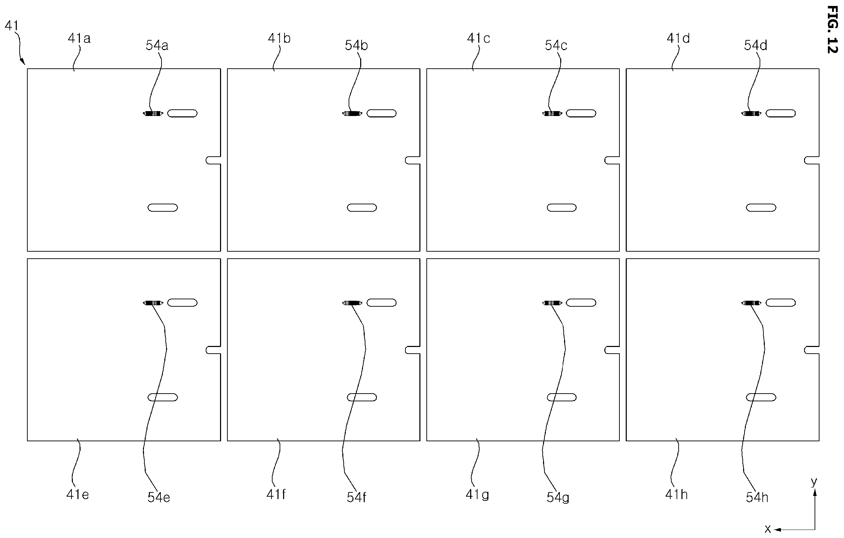

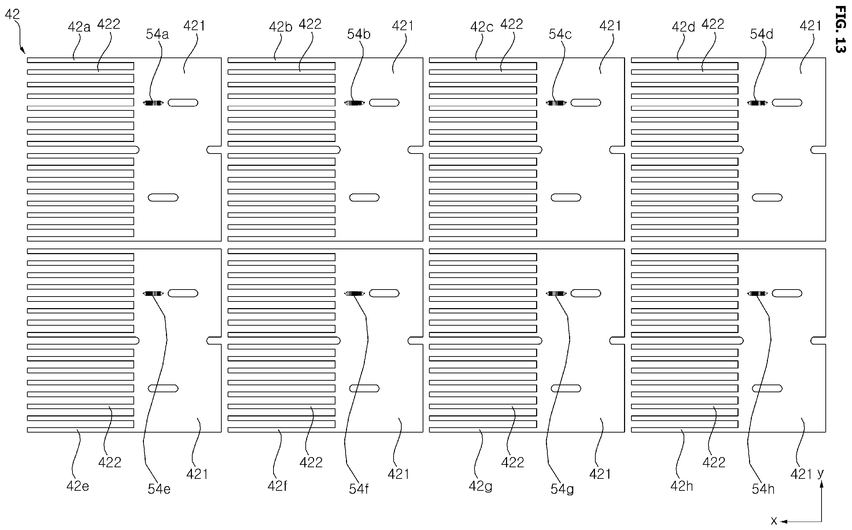

Referring to FIGS. 12 and 13, a plurality of connectors 54a, 54b, 54c, 54d, 54e, 54f, 54g, and 54h may be mounted on the rear surface of the plurality of substrates 41; 42. The number of connectors 54a, 54b, 54c, 54d, 54e, 54f, 54g, and 54h may be equal to the number of substrates 41; 42.

Referring to FIG. 12, each of a plurality of substrates 41a, 41b, 41c, 41d, 41e, 41g, 41h may have a plate shape (see FIG. 5). A first connector 54a may be coupled to a rear surface of a first substrate 41a, and a second connector 54b may be coupled to a rear surface of a second substrate 41b. A third connector 54c may be coupled to a rear surface of a third substrate 41c, and a fourth connector 54d may be coupled to a rear surface of a fourth substrate 41d. A fifth connector 54e may be coupled to a rear surface of a fifth substrate 41e, and a sixth connector 54f may be coupled to a rear surface of a sixth substrate 41f. A seventh connector 54g may be coupled to a rear surface of a seventh substrate 41g, and an eighth connector 54h may be coupled to a rear surface of an eighth substrate 41h.

Referring to FIG. 13, each of a plurality of substrates 42a, 42b, 42c, 42d, 42e, 42f, 42g, and 42h may have a fork shape (see FIG. 9). The first connector 54a may be coupled to a rear surface of the body 421 of the first substrate 42a, and the second connector 54b may be coupled to a rear surface of the body 421 of the second substrate 42b. The third connector 54c may be coupled to a rear surface of the body 421 of the third substrate 42c, and the fourth connector 54d may be coupled to a rear surface of the body 421 of the fourth substrate 42d. The fifth connector 54e may be coupled to a rear surface of the body 421 of the fifth substrate 42e, and the sixth connector 54f may be coupled to a rear surface of the body 421 of the sixth substrate 42f. The seventh connector 54g may be coupled to a rear surface of the body 421 of the seventh substrate 42g, and the eighth connector 54h may be coupled to a rear surface of the body 421 of the eighth substrate 42h.

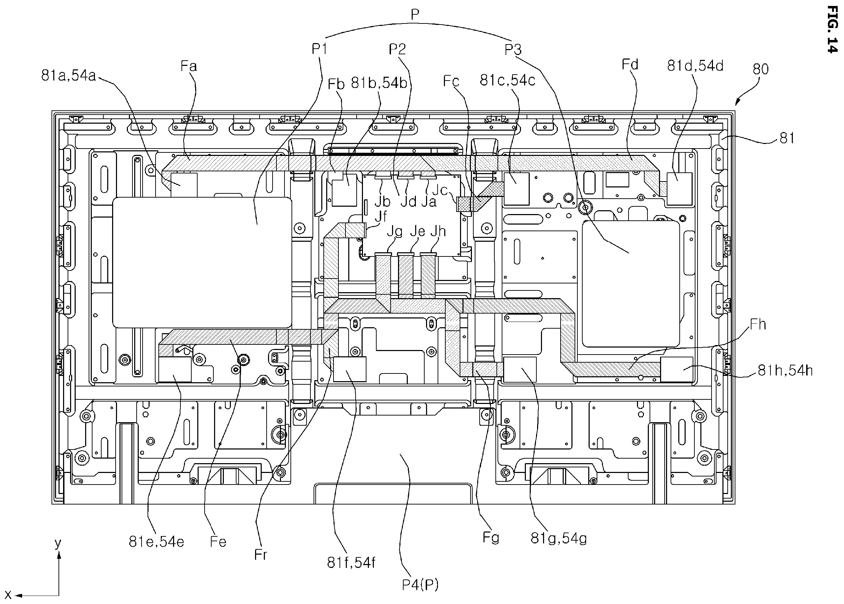

Referring to FIG. 14, the LED driver P2 may be electrically connected to the connectors 54a, 54b, 54c, 54d, 54e, 54f, 54g, and 54h through cables Fa, Fb, Fc, Fd, Fe, Ff, Fg, and Fh. The cables Fa, Fb, Fc, Fd, Fe, Ff, Fg, and Fh may be Flexible Flat Cables (FFC). A Micro Controller Unit (MCU) of the LED driver P2 may receive, from the main board P3, data about the brightness of the plurality of light sources 51 mounted on the plurality of substrates 41; 42, and may convert (process) the received data and provide the data to a driver IC of the LED driver P2. The driver IC may be connected to the substrates 41; 42 through the connectors 54a, 54b, 54c, 54d, 54e, 54f, 54g, and 54h and the cables Fa, Fb, Fc, Fd, Fe, Ff, Fg, and Fh, and may control the brightness of the light sources 51 by adjusting the amount of current flowing through the light sources 51 mounted on the respective substrates or by blocking the flow of current.

One end of a first cable Fa may be connected to a first connector Ja of the LED driver P2, and another end of the first cable Fa may be connected to the first connector 54a through a first frame hole 81a.

One end of a second cable Fb may be connected to a second connector Jb of the LED driver P2, and another end of the second cable Fb may be connected to the second connector 54b through a second frame hole 81b.

One end of a third cable Fc may be connected to a third connector Jc of the LED driver P2, and another end of the third cable Fc may be connected to the third connector 54c through a third frame hole 81c.

One end of a fourth cable Fd may be connected to a fourth connector Jd of the LED driver P2, and another end of the fourth cable Fd may be connected to the fourth connector 54d through a fourth frame hole 81d.

One end of a fifth cable Fe may be connected to a fifth connector Je of the LED driver P2, and another end of the fifth cable Fe may be connected to the fifth connector 54e through a fifth frame hole 81e.

One end of a sixth cable Ff may be connected to a sixth connector Jf of the LED driver P2, and another end of the sixth cable Ff may be connected to the sixth connector 54f through a sixth frame hole 81f.

One end of a seventh cable Fg may be connected to a seventh connector Jg of the LED driver P2, and another end of the seventh cable Fg may be connected to the seventh connector 54g through a seventh frame hole 81g.

One end of an eighth cable Fh may be connected to an eighth connector Jh of the LED driver P2, and another end of the eighth cable Fh may be connected to the eighth connector 54h through an eighth frame hole 81h.

That is, in order for the LED driver P2 to be connected to the plurality of substrates 41 (see FIG. 12) and 42 (see FIG. 13), the same number of cables Fa, Fb, Fc, Fd, Fe, Ff, Fg, and Fh as the substrates 41; 42, may be required. Due to the use of a large number of cables Fa, Fb, Fc, Fd, Fe, Ff, Fg, and Fh, manufacturing costs of the display device may increase, and a connection structure between the LED driver P2 and the substrates 41; 42 may become complicated.

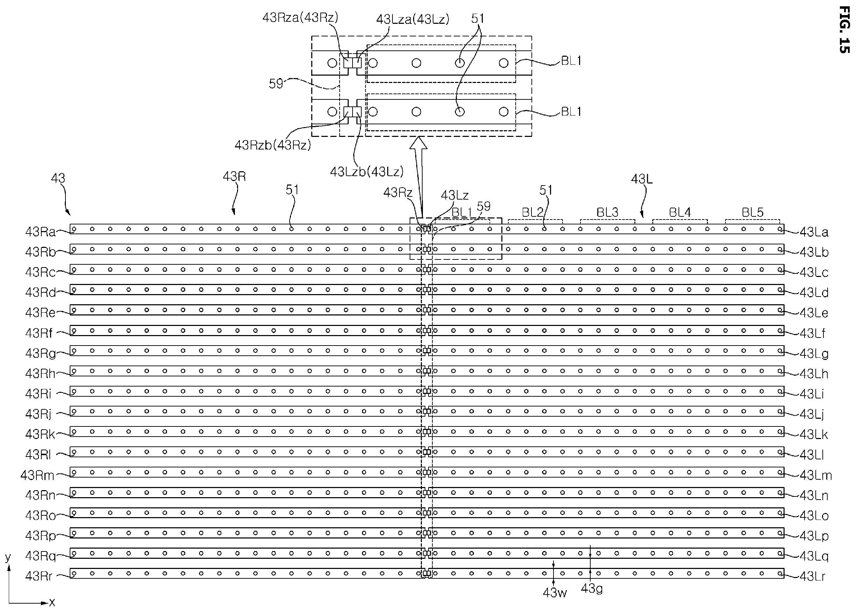

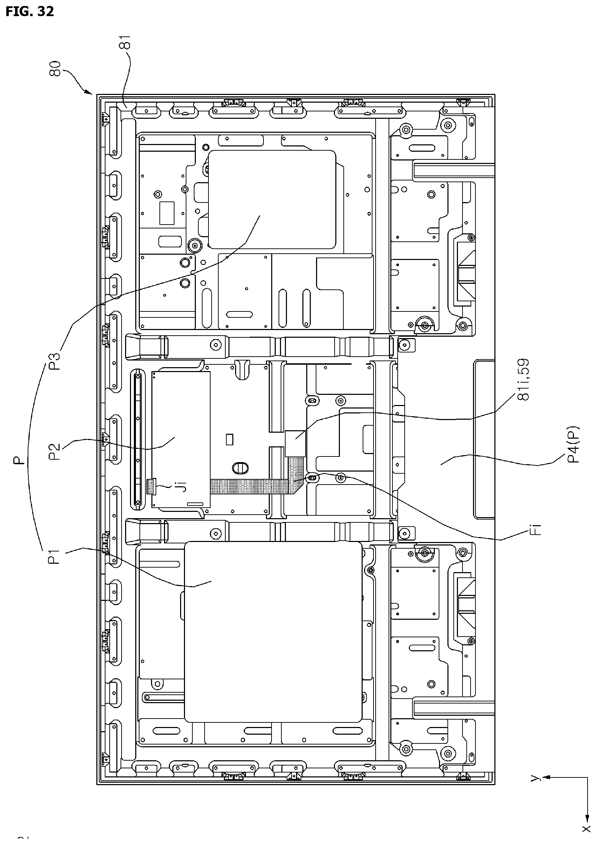

Referring to FIG. 15, a substrate 43 may be coupled to the front surface of the frame 80 (see FIG. 32) or the front surface of the heat sink 83. The substrate 43 may be a printed circuit board (PCB). For example, the substrate 43 may be made of at least one of polyethylene terephthalate (PET), glass, polycarbonate (PC), and silicon. The substrate 43 may have a bar shape.

Each of a plurality of substrates 43 may be elongated. The plurality of substrates 43 may be spaced apart from each other in a direction perpendicular to a longitudinal direction of the substrate 43. The longitudinal direction of the substrate 43 may be defined in a horizontal direction.

An extension board 59 may extend in a direction (e.g., vertical direction) in which the substrates 43 are spaced apart from each other. For example, the plurality of substrates 43 may extend from one long side of the extension board 59 in a direction (e.g., horizontal direction) intersecting the extension board 59. In another example, the plurality of substrates 43 may include a plurality of first substrates 43L and a plurality of second substrates 43R which are opposite to each other with respect to the extension board 59. The plurality of first substrates 43L and the plurality of second substrates 43R may be aligned or misaligned with each other in a longitudinal direction of the substrate 43. The plurality of first substrates 43L and the plurality of second substrates 43R may have the same shape.

A plurality of first substrates 43La, 43Lb, 43Lc, 43Ld, 43Le, 43Lf, 43Lg, 43Lh, 43Li, 43Lj, 43Lk, 43Ll 43Lm, 43Ln, 43Lo, 43Lp, 43Lq, and 43Lr may be adjacent to a first long side (e.g., left side) of the extension board 59 and may be electrically connected to the extension board 59 through a plurality of first connectors 43Lz.

A plurality of second substrates 43Ra, 43Rb, 43Rc, 43Rd, 43Re, 43Rf, 43Rg, 43Rh, 43Ri, 43Rj, 43Rk, 43RI 43Rm, 43Rn, 43Ro, 43Rp, 43Rq, and 43Rr may be adjacent to a second long side (e.g., right side) of the extension board 59 and may be electrically connected to the extension board 59 through a plurality of second connectors 43Rz.

The plurality of light sources 51 may be arranged in a matrix on the front surface of the plurality of substrates 43. The reflective sheet(s) 60 (see FIG. 2) may have holes in which the light sources 51 or the lenses covering the light sources 51 are disposed.

Accordingly, the extension board 59 may be electrically connected to the plurality of substrates 43 through the plurality of connectors 43Lz and 43Rz. The LED driver P2 may be electrically connected to a connector of the extension board 59 through a cable Fi (see FIG. 32). The cable Fi may be a Flexible Flat Cable (FFC). The connectivity of the LED driver P2 may be expanded to the plurality of substrates 43 through the extension board 59.

Each of the plurality of substrates 43 is connected to the extension board 59 through each of the plurality of connectors 43Lz and 43Rz, such that local dimming blocks may be formed independently on each of the plurality of substrates 43. The light sources 51, mounted on each of the plurality of substrates 43, may be arranged in one line in a longitudinal direction of the substrate 43 and may be sequentially grouped into local dimming blocks in the longitudinal direction of the substrate 43.

For example, 20 light sources 51 may be arranged in a line on a first substrate 43La, and the light sources 51 may be grouped by N number into local diming blocks. Here, N is a natural number greater than or equal to 1, and if the light sources 51 are grouped by fours into local dimming blocks, the number of local dimming blocks BL1, BL2, BL3, BL4, BL5 is five. The local dimming blocks of the first substrate 43La may be formed independently of the local dimming blocks of each of the remaining first substrates 43Lb, 43Lc, 43Ld, 43Le, 43Lf, 43Lg, 43Lh, 43Li, 43Lj, 43Lk, 43Ll, 43Lm, 43Ln, 43Lo, 43Lp, 43Lq, and 43Lr, and may also be formed independently of the local dimming blocks of each of the plurality of second substrates 43Ra, 43Rb, 43Rc, 43Rd, 43Re, 43Rf, 43Rg, 43Rh, 43Ri, 43Rj, 43Rk, 43RI 43Rm, 43Rn, 43Ro, 43Rp, 43Rq, and 43Rr.

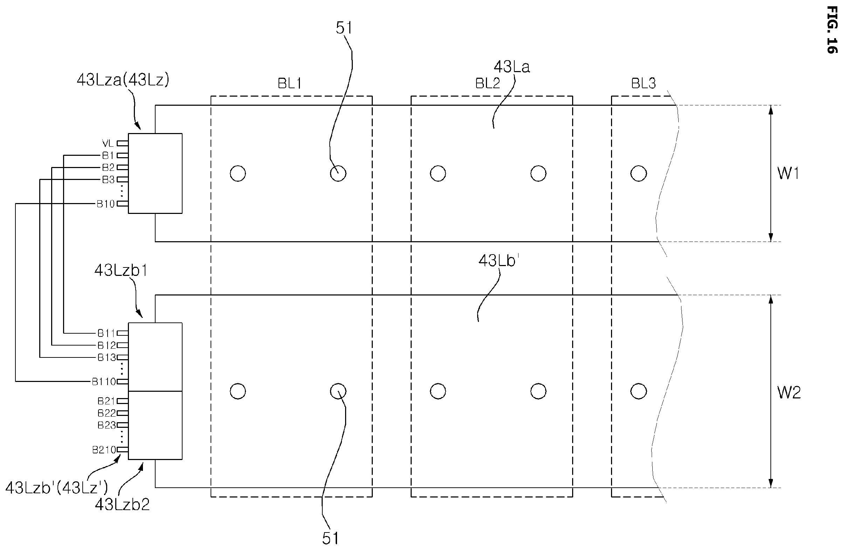

Referring to FIG. 16, a first connector 43Lza may be mounted to the first substrate 43La, and a first connector 43Lzb' may be mounted to the first substrate 43Lb'. The first connector 43Lza may be connected to an input connector 43Lzb1 of the first connector 43Lzb'. The input connector 43Lzb1 may be connected to an output connector 43Lzb2 of the first connector 43Lzb'. The light sources 51 arranged in a line on the first substrate 43La and the light sources 51 arranged in a line on the first substrate 43Lb' may be grouped by N number into local dimming blocks.

For example, 20 light sources 51 may be arranged in a line on the first substrate 43La, and 20 light sources 51 may be arranged in a line on the first substrate 43Lb'. The light sources 51, arranged in two lines on the first substrates 43La and 43Lb', may be grouped by N number into local dimming blocks. Here, N is an even number greater than or equal to 2, and if the light sources 51 are grouped by fours into local dimming blocks, the number of local dimming blocks BL1, BL2, BL3, BL4, BL5, BL6, BL7, BL8, BL9, BL10 is ten. Power VL of the first connector 43Lza may be sequentially supplied to a first local dimming block BL1, a second local dimming block BL2, a third local dimming block BL3, a fourth local dimming block BL4, a fifth local dimming block BL5, a sixth local dimming block BL6, a seventh local dimming block BL7, an eighth local dimming block BL8, a ninth local dimming block BL9, and a tenth local dimming block BL10.

In this case, the power VL may be connected to two light sources 51 on the first substrate 43La which are in the first local dimming block BL1, and may be connected to two light sources 51 on the first substrate 43Lb', which are included in the first local dimming block BL1, via a first pin B1 of the first connector 43Lza and a first pin B11 of the input connector 43Lzb1. In addition, two light sources 51 on the first substrate 43Lb', which are in the first local dimming block BL1, may be connected to a first pin B21 of the output connector 43Lzb2.

The power VL, two light sources 51 on the first substrate 43La which are in the second local dimming block BL2, a second pin B2 of the first connector 43Lza, a second pin B12 of the input connector 43Lzb1, two light sources 51 on the first substrate 43Lb' which are in the second local dimming block BL2, and a second pin B22 of the output connector 43Lzb2 may be sequentially connected.

The power VL, two light sources 51 on the first substrate 43La which are in the third local dimming block BL3, a third pin B3 of the first connector 43Lza, a third pin B13 of the input connector 43Lzb1, two light sources 51 on the first substrate 43Lb' which are in the third local dimming block BL3, and a third pin B23 of the output connector 43Lzb2 may be sequentially connected.

The power VL, two light sources 51 on the first substrate 43La which are in the fourth local dimming block BL4, a fourth pin B4 of the first connector 43Lza, a fourth pin B14 of the input connector 43Lzb1, two light sources 51 on the first substrate 43Lb' which are in the fourth local dimming block BL4, and a fourth pin B24 of the output connector 43Lzb2 may be sequentially connected.

The power VL, two light sources 51 on the first substrate 43La which are in the fifth local dimming block BL5, a fifth pin B5 of the first connector 43Lza, a fifth pin B15 of the input connector 43Lzb1, two light sources 51 on the first substrate 43Lb' which are in the fifth local dimming block BL5, and a fifth pin B25 of the output connector 43Lzb2 may be sequentially connected.

The power VL, two light sources 51 on the first substrate 43La which are in the sixth local dimming block BL6, a sixth pin B6 of the first connector 43Lza, a sixth pin B16 of the input connector 43Lzb1, two light sources 51 on the first substrate 43Lb' which are in the sixth local dimming block BL6, and a sixth pin B26 of the output connector 43Lzb2 may be sequentially connected.

The power VL, two light sources 51 on the first substrate 43La which are in the seventh local dimming block BL7, a seventh pin B7 of the first connector 43Lza, a seventh pin B17 of the input connector 43Lzb1, two light sources 51 on the first substrate 43Lb' which are in the seventh local dimming block BL7, and a seventh pin B27 of the output connector 43Lzb2 may be sequentially connected.

The power VL, two light sources 51 on the first substrate 43La which are in the eighth local dimming block BL8, an eighth pin B8 of the first connector 43Lza, an eighth pin B18 of the input connector 43Lzb1, two light sources 51 on the first substrate 43Lb' which are in the eighth local dimming block BL8, and an eighth pin B28 of the output connector 43Lzb2 may be sequentially connected.

The power VL, two light sources 51 on the first substrate 43La which are in the ninth local dimming block BL9, a ninth pin B9 of the first connector 43Lza, a ninth pin B19 of the input connector 43Lzb1, two light sources 51 on the first substrate 43Lb' which are in the ninth local dimming block BL9, and a ninth pin B29 of the output connector 43Lzb2 may be sequentially connected.

The power VL, two light sources 51 on the first substrate 43La which are in the tenth local dimming block BL10, a tenth pin B10 of the first connector 43Lza, a tenth pin B110 of the input connector 43Lzb1, two light sources 51 on the first substrate 43Lb' which are in the tenth local dimming block BL10, and a tenth pin B210 of the output connector 43Lzb2 may be sequentially connected.

The above power VL may be power VLED supplied from the power supply board P1 to the first connector 43Lza through the LED driver P2 and the extension board 59 (see FIG. 32). The pins B21, B22, B23, B24, B25, B26, B27, B28, B29, and B210 of the output connector 43Lzb2 described above may be connected to the driver IC of the extension board 59. Accordingly, local dimming may be implemented by controlling the brightness of the light sources 51 which are included in the respective local dimming blocks BL1, BL2, BL3, BL4, BL5, BL6, BL7, BL8, BL9, and BL10.

Each of the first substrate 43La and the first substrate 43Lb described above with reference to FIG. 15 includes five local dimming blocks each having four light sources 51, but the first substrate 43La and the first substrate 43Lb' described above with reference to FIG. 16 may include 10 local dimming blocks each having four light sources 51.

Accordingly, the structure described above with reference to FIG. 16 may achieve a better local dimming effect than the structure described above with reference to FIG. 15. However, in order to group the light sources 51 of the first substrates 43La and 43Lb' by N number into local dimming blocks, the first connector 43Lzb' connected to the first substrate 43Lb' requires the input connector 43Lzb1 and the output connector 43Lzb2, such that a width W2 of the first substrate 43Lb' becomes greater than a width W1 of the first substrate 43La. That is, the structure of FIG. 16 may have higher substrate manufacturing costs than the structure of FIG. 15.

Referring to FIGS. 17 and 18, a substrate 44 may be coupled to the front surface of the frame 80 (see FIG. 32) or the front surface of the heat sink 83. The substrate 44 may be a printed circuit board (PCB). For example, the substrate 44 may be made of at least one of polyethylene terephthalate (PET), glass, polycarbonate (PC), and silicon. The substrate 44 may have a bar shape.

Each of a plurality of substrates 44 may be elongated. The plurality of substrates 44 may be spaced apart from each other in a direction perpendicular to a longitudinal direction of the substrate 44. The longitudinal direction of the substrate 44 may be defined in a horizontal direction.

An extension board 59 may extend in a direction (e.g., vertical direction) in which the substrates 44 are spaced apart from each other. For example, the plurality of substrates 44 may extend from one long side of the extension board 59 in a direction (e.g., horizontal direction) intersecting the extension board 59. In another example, the plurality of substrates 44 may include a plurality of first substrates 44L and a plurality of second substrates 44R which are opposite to each other with respect to the extension board 59. The plurality of first substrates 44L and the plurality of second substrates 44R may be aligned or misaligned with each other in a longitudinal direction of the substrate 44. The plurality of first substrates 44L and the plurality of second substrates 44R may have the same shape.

A plurality of first substrates 44La, 44Lb, 44Lc, 44Ld, 44Le, 44Lf, 44Lg, 44Lh, and 44Li may be adjacent to a first long side (e.g., left side) of the extension board 59 and may be electrically connected to the extension board 59 through a plurality of first connectors 44Lz.

A plurality of second substrates 44Ra, 44Rb, 44Rc, 44Rd, 44Re, 44Rf, 44Rg, 44Rh, and 44Ri may be adjacent to a second long side (e.g., right side) of the extension board 59 and may be electrically connected to the extension board 59 through a plurality of second connectors 44Rz.

The plurality of light sources 51 may be arranged in a matrix on the front surface of the plurality of substrates 44. The reflective sheet(s) 60 (see FIG. 2) may have holes in which the light sources 51 or the lenses covering the light sources 51 are disposed.

Accordingly, the extension board 59 may be electrically connected to the plurality of substrates 44 through the plurality of connectors 44Lz and 44Rz. The LED driver P2 may be electrically connected to a connector of the extension board 59 through a cable Fi (see FIG. 32). The cable Fi may be a Flexible Flat Cable (FFC). The connectivity of the LED driver P2 may be expanded to the plurality of substrates 44 through the extension board 59.

Each of the plurality of substrates 44 is connected to the extension board 59 through each of the plurality of connectors 44Lz and 44Rz, such that local dimming blocks may be formed independently on each of the plurality of substrates 44. The light sources 51, mounted on each of the plurality of substrates 44, may be arranged in two lines in a longitudinal direction of the substrate 44 and may be sequentially grouped into local dimming blocks in the longitudinal direction of the substrate 44.

For example, 40 light sources 51 may be arranged in two lines on a first substrate 44La, and the light sources 51 in two lines may be grouped by N number into local diming blocks. Here, N is a natural number greater than or equal to 2, and if the light sources 51 are grouped by fours into local dimming blocks, the number of local dimming blocks BL1, BL2, BL3, BL4, BL5, BL6, BL7, BL8, BL9, and BL10 is ten. The local dimming blocks of the first substrate 44La may be formed independently of the local dimming blocks of each of the remaining first substrates 44Lb, 44Lc, 44Ld, 44Le, 44Lf, 44Lg, 44Lh, and 44Li, and may also be formed independently of the local dimming blocks of each of the plurality of second substrates 44Ra, 44Rb, 44Rc, 44Rd, 44Re, 44Rf, 44Rg, 44Rh, and 44Ri.

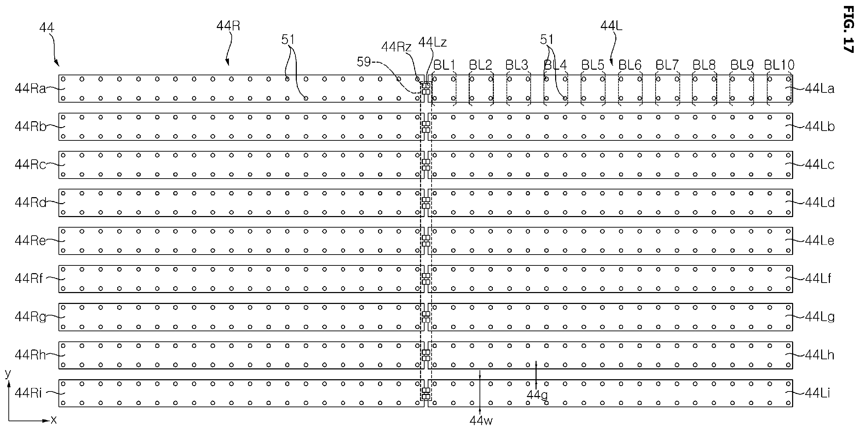

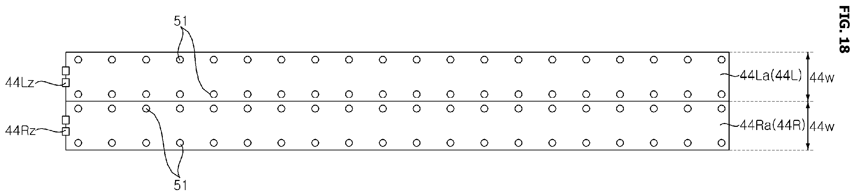

Accordingly, the structure described above with reference to FIGS. 17 and 18 may achieve a better local dimming effect than the structure described above with reference to FIG. 15. Further, in the structure described above with reference to FIGS. 17 and 18, each of the plurality of connectors 44Lz and 44Rz merely has a power source and the same number of pins as the number of local dimming blocks, without further including the input and output connectors of FIG. 16. However, in the case where the light sources 51 have the same pitch, a width 44w of the substrate 44 of FIGS. 17 and 18 may be greater than a width 43w of the substrate 43 of FIG. 15. A difference between the width 44w and the width 43w may be equal to a gap 43g between the substrates 43 of FIG. 15. That is, the structure of FIGS. 17 and 18 may have higher substrate manufacturing costs than the structure of FIG. 15.

Meanwhile, the first substrate 44L may have the same shape as the second substrate 44R. For example, a single substrate may be cut by a cutting process to be divided into the plurality of first substrates 44L and the plurality of second substrates 44R.

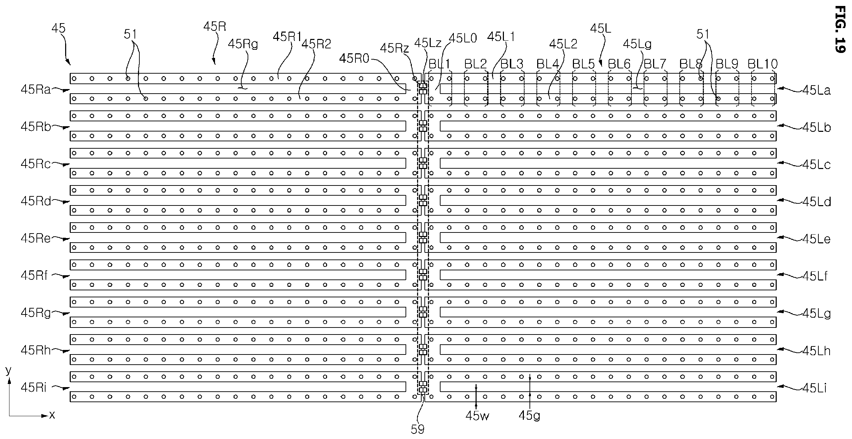

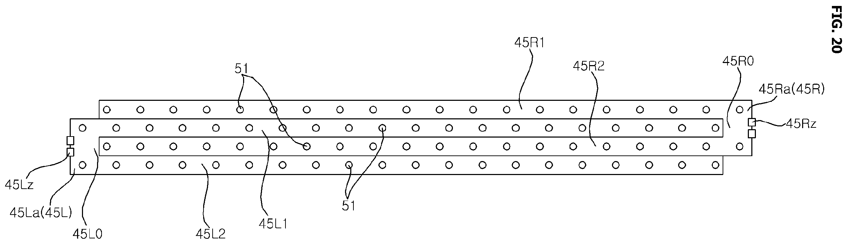

Referring to FIGS. 19 and 20, a substrate 45 may be coupled to the front surface of the frame 80 (see FIG. 32) or the front surface of the heat sink 83. The substrate 45 may be a printed circuit board (PCB). For example, the substrate 45 may be made of at least one of polyethylene terephthalate (PET), glass, polycarbonate (PC), and silicon. The substrate 45 may be in the shape of tongs, a tuning fork, or a chain.

The substrate 45 may have a body 45L0; 45R0 and a pair of legs 45L1, 45L2; 45R1, 45R2. The body 45L0; 45R0 may be elongated. The pair of legs 45L1, 45L2; 45R1, 45R2 may extend from one long side of the body 45L0; 45R0 in a direction intersecting the body 45L0; 45R0, and may be spaced apart from each other in a longitudinal direction of the body 45L0; 45R0. The longitudinal direction of the body 45L0; 45R0 may be defined in a vertical direction, and the longitudinal direction of the pair of legs 45L1, 45L2; 45R1, 45R2 may be defined in a horizontal direction. The length of the pair of legs 45L1, 45L2; 45R1, 45R2 may be greater than the length of the body 45L0; 45R0.

The longitudinal direction of the plurality of substrates 45 may be the same as the longitudinal direction of the pair of legs 45L1, 45L2; 45R1, 45R2. The plurality of substrates 45 may be spaced apart from each other in a direction perpendicular to the longitudinal direction of the substrates 45.

An extension board 59 may extend in a direction (e.g., vertical direction) in which the substrates 45 are spaced apart from each other. For example, the plurality of substrates 45 may extend from one long side of the extension board 59 in a direction (e.g., horizontal direction) intersecting the extension board 59. In another example, the plurality of substrates 45 may include a plurality of first substrates 45L and a plurality of second substrates 45R which are opposite to each other with respect to the extension board 59. The plurality of first substrates 45L and the plurality of second substrates 45R may be aligned or misaligned with each other in a longitudinal direction of the substrate 45. The plurality of first substrates 45L and the plurality of second substrates 45R may have the same shape.

A plurality of first substrates 45La, 45Lb, 45Lc, 45Ld, 45Le, 45Lf, 45Lg, 45Lh, and 45Li may be adjacent to a first long side (e.g., left side) of the extension board 59 and may be electrically connected to the extension board 59 through a plurality of first connectors 45Lz.

A plurality of second substrates 45Ra, 45Rb, 45Rc, 45Rd, 45Re, 45Rf, 45Rg, 45Rh, and 45Ri may be adjacent to a second long side (e.g., right side) of the extension board 59 and may be electrically connected to the extension board 59 through a plurality of second connectors 45Rz.

The plurality of light sources 51 may be arranged in a matrix on the front surface of the plurality of substrates 45. The reflective sheet(s) 60 (see FIG. 2) may have holes in which the light sources 51 or the lenses covering the light sources 51 are disposed.

Accordingly, the extension board 59 may be electrically connected to the plurality of substrates 45 through the plurality of connectors 45Lz and 45Rz. The LED driver P2 may be electrically connected to a connector of the extension board 59 through a cable Fi (see FIG. 32). The cable Fi may be a Flexible Flat Cable (FFC). The connectivity of the LED driver P2 may be expanded to the plurality of substrates 45 through the extension board 59.

Each of the plurality of substrates 45 is connected to the extension board 59 through each of the plurality of connectors 45Lz and 45Rz, such that local dimming blocks may be formed independently on each of the plurality of substrates 45. The light sources 51, mounted on each of the plurality of substrates 45, may be arranged in two lines in a longitudinal direction of the substrate 45 and may be sequentially grouped into local dimming blocks in the longitudinal direction of the substrate 45. In this case, some of the light sources 51 may be arranged in a line along a first leg 45L1; 45R1, and the remaining light sources 51 may be arranged in a line along a second leg 45L2; 45R2.

For example, 40 light sources 51 may be arranged in two lines along the first and second legs 45L1 and 45L2 of the first substrate 45La, and the light sources 51 in two lines may be grouped by N number into local diming blocks. Here, N is a natural number greater than or equal to 2, and if the light sources 51 in two lines are grouped by fours into local dimming blocks, the number of local dimming blocks BL1, BL2, BL3, BL4, BL5, BL6, BL7, BL8, BL9, and BL10 is ten. The local dimming blocks of the first substrate 45La may be formed independently of the local dimming blocks of each of the remaining first substrates 45Lb, 45Lc, 45Ld, 45Le, 45Lf, 45Lg, 45Lh, and 45Li, and may also be formed independently of the local dimming blocks of each of the plurality of second substrates 45Ra, 45Rb, 45Rc, 45Rd, 45Re, 45Rf, 45Rg, 45Rh, and 45Ri.

Accordingly, the structure described above with reference to FIGS. 19 and 20 may achieve a better local dimming effect than the structure described above with reference to FIG. 15. Further, in the structure described above with reference to FIGS. 19 and 20, each of the plurality of connectors 44Lz and 44Rz merely has a power source and the same number of pins as the number of local dimming blocks, without further including the input and output connectors of FIG. 16. In addition, in the case where the light sources 51 have the same pitch, a width 45w of the leg of the substrate 45 of FIGS. 19 and 20 may be greater than a width 43w of the substrate 43 of FIG. 15.

Meanwhile, the first substrate 45L may have the same shape as the second substrate 45R. For example, a single substrate may be cut by a cutting process to be divided into the plurality of first substrates 45L and the plurality of second substrates 45R. A gap 45g between the pair of legs 45L1, 45L2; 45R1, 45R2 may be equal to the width 45w of each of the pair of legs 45L1, 45L2; 45R1, 45R2.

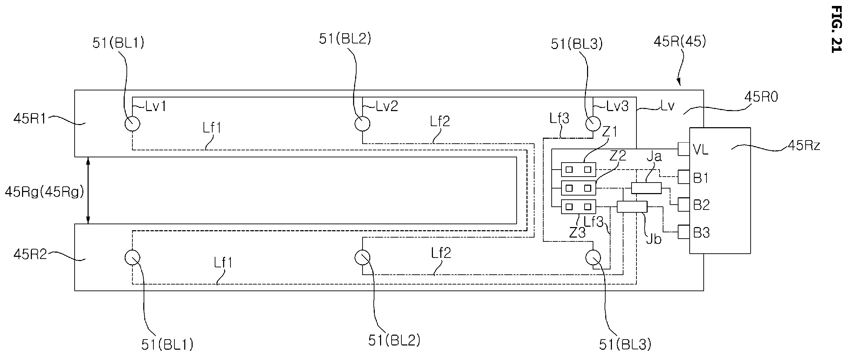

Referring to FIG. 21, the arrangement of wires and components on the substrate 45 will be described using the second substate 45R as an example. Some of the light sources 51 may be mounted on the first leg 45R1 and the body 45R0 in a longitudinal direction of the first leg 45R1. The remaining light sources 51 may be mounted on the second leg 45R2 and the body 45R0 in a longitudinal direction of the second leg 45R2. Lines Lv, Lf1, Lf2, and Lf3 which will be described below may be circuits.

A power line Lv (shown by a solid line) may be connected to the power VL of the second connector 45Rz, and may be wired to the first leg 45R1. The power line Lv may be adjacent to an upper side of the first leg 45R1, and some of the lines Lf1, Lf2, and Lf3 may be adjacent to a lower side of the first leg 45R1. The power line Lv may branch into a number corresponding to the number of local dimming blocks. A first branch line Lv1 may be connected to the light sources 51 of the first leg 45R1 which are in the first local dimming block BL1. A second branch line Lv2 may be connected to the light sources 51 of the first leg 45R1 which are in the second local dimming block BL2. A third branch line Lv3 may be connected to the light sources 51 of the first leg 45R1 which are in the third local dimming block BL3.

A first line Lf1 (shown by a dotted line) may be connected to the first branch line Lv1 and may pass through the light sources 51 of the second leg 45R2, which are in the first local dimming block BL1, to be connected to the first pin B1 of the second connector 45Rz.

A second line Lf2 (shown by a two-dot-dashed line) may be connected to the second branch line Lv2 and may pass through the light sources 51 of the second leg 45R2, which are in the second local dimming block BL2, to be connected to the second pin B2 of the second connector 45Rz.

A third line Lf3 (shown by a one-dot-dashed line) may be connected to the third branch line Lv3 and may pass through the light sources 51 of the third leg 45R3, which are in the third local dimming block BL3, to be connected to the third pin B3 of the second connector 45Rz.

The above power VL may be power VLED supplied from the power supply board P1 to the first connector 43Lza through the LED driver P2 and the extension board 59 (see FIG. 32). The pins B1, B2, and B3 of the connector 45Rz described above may be connected to the driver IC of the extension board 59 (see FIG. 19). The above lines Lf1, Lf2, and Lf3 may be referred to as feedback lines Lf1, Lf2, and Lf3.

The power VL may be supplied to the first local dimming block BL1 through the first branch line Lv1, and a current having passed through the first local dimming block BL1 may flow to the driver IC through the first line Lf1 and the first pin B1. Likewise, the power VL may be supplied to each of the second and third local dimming blocks BL2 and BL3 through the second and third branch lines Lv2 and Lv3, respectively, and a current having passed through each of the second and third local dimming blocks BL2 and BL3 may flow to the driver IC through each of the second and third lines Lf2 and Lf3 and each of the second and third pins B2 and B3. In this case, the driver IC may control the brightness of the light sources 51, included in the respective local dimming blocks BL1, BL2, and BL3, by adjusting the amount of current flowing through the light sources 51 which are included in the respective local dimming blocks BL1, BL2, and BL3, or by blocking the flow of current, and as a result may implement local dimming.

Diodes Z1, Z2, and Z3 may be mounted on the body 45R0. The diodes Z1, Z2, and Z3 may be ESD Protection Diodes for preventing electrostatic discharge (ESD). The diodes Z1, Z2, and Z3 may be Zener diodes. One side of a first diode Z1 may be connected to a voltage line Lv, and another side of the first diode Z1 may be connected to the first line Lf1. One side of a second diode Z2 may be connected to the voltage line Lv, and another side of the second diode Z2 may be connected to the second line Lf2. One side of a third diode Z3 may be connected to the voltage line Lv, and another side of the third diode Z3 may be connected to the third line Lf3. Jumpers Ja and Jb may be mounted on the body 45R0 and may connect wires on the body 45R0.

In this case, the diodes Z1, Z2, and Z3 may be concentrated in a specific area of the body 45R0. That is, at positions of the diodes Z1, Z2, and Z3, the reflective sheet 60 (see FIG. 2) on the substrate 45 may be lifted by a height corresponding to the height of the diodes Z1, Z2, and Z3. Due to the lifting of the reflective sheet 60, a distance between the display panel 10 and the reflective sheet 60 may decrease, thereby resulting in a lower image quality.

In addition, the first and second legs 45R1 and 45R2 of the substrate 45 are spaced apart from each other in an area other than the body 45R0, such that the rigidity of the substrate 45 may be weak. For this reason, the substrate 45 may be bent or damaged, and users may have difficulty in fixing the substrate 45 to the frame.

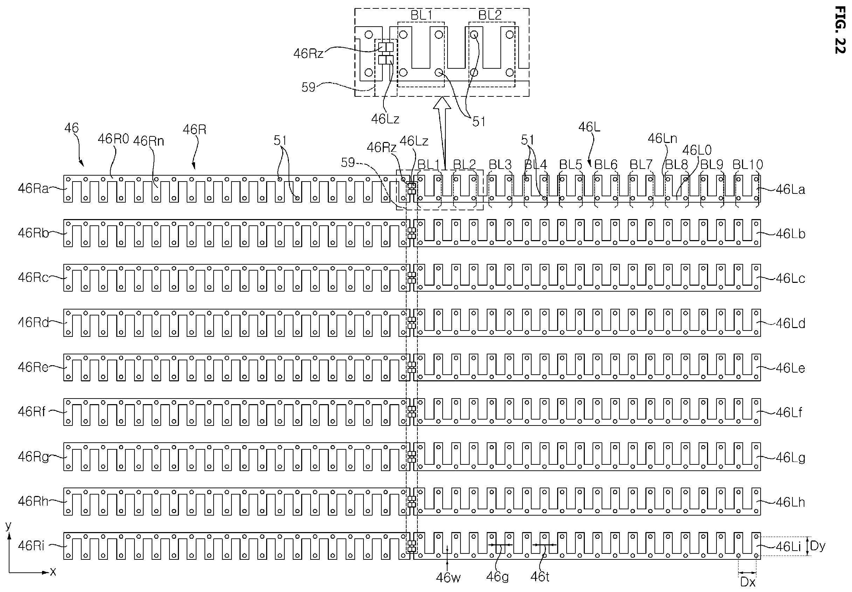

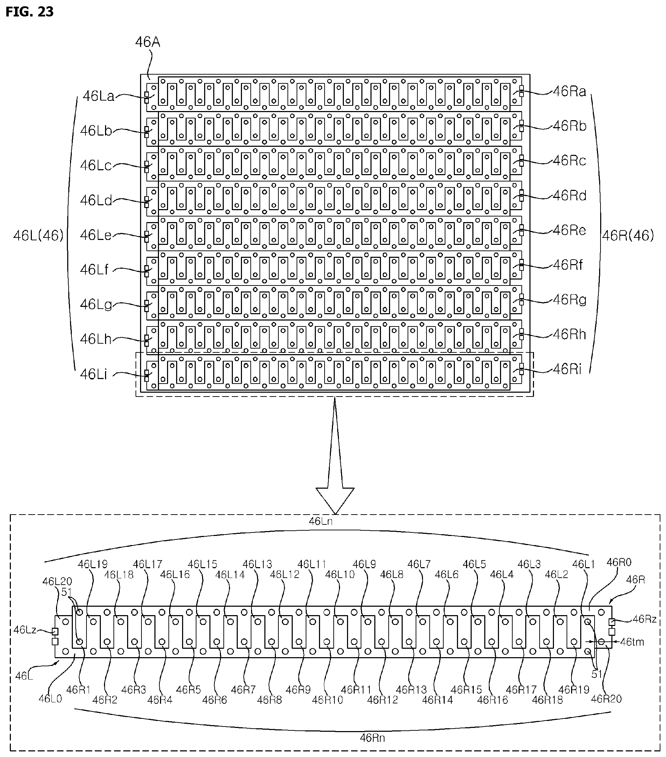

Referring to FIGS. 22 and 23, a substrate 46 may be coupled to the front surface of the frame 80 (see FIG. 32) or the front surface of the heat sink 83. The substrate 46 may be a printed circuit board (PCB). For example, the substrate 46 may be made of at least one of polyethylene terephthalate (PET), glass, polycarbonate (PC), and silicon. The substrate 45 may be in the shape of a comb or a saw blade.

The substrate 46 may have a body 46L0; 46R0 and a plurality of legs 46Ln; 46Rn. The body 46L0; 46R0 may be elongated. The plurality of legs 46Ln; 46Rn may extend from one long side of the body 46L0; 46R0 in a direction intersecting the body 46L0; 46R0, and may be spaced apart from each other in a longitudinal direction of the body 46L0; 46R0. The longitudinal direction of the body 46L0; 46R0 may be defined in a horizontal direction, and the longitudinal direction of the plurality of legs 46Ln; 46Rn may be defined in a vertical direction. The length of the plurality of legs 46Ln; 46Rn may be smaller than the length of the body 46L0; 46R0. The body 46L0; 46R0 may be referred to as a base 46L0; 46R0, and the legs 46Ln; 46Rn may be referred to as a protruding portion 46Ln; 46Rn.

The longitudinal direction of the plurality of substrates 46 may be the same as the longitudinal direction of the body 46L0; 46R0. The plurality of substrates 46 may be spaced apart from each other in a direction perpendicular to the longitudinal direction of the substrates 46.

An extension board 59 may extend in a direction (e.g., vertical direction) in which the substrates 46 are spaced apart from each other. For example, the plurality of substrates 46 may extend from one long side of the extension board 59 in a direction (e.g., horizontal direction) intersecting the extension board 59. In another example, the plurality of substrates 46 may include a plurality of first substrates 46L and a plurality of second substrates 46R which are opposite to each other with respect to the extension board 59. The plurality of first substrates 46L and the plurality of second substrates 46R may be aligned or misaligned with each other in a longitudinal direction of the substrate 46. The plurality of first substrates 46L and the plurality of second substrates 46R may have the same shape.

A plurality of first substrates 46La, 46Lb, 46Lc, 46Ld, 46Le, 46Lf, 46Lg, 46Lh, and 46Li may be adjacent to a first long side (e.g., left side) of the extension board 59 and may be electrically connected to the extension board 59 through a plurality of first connectors 46Lz.

A plurality of second substrates 46Ra, 46Rb, 46Rc, 46Rd, 46Re, 46Rf, 46Rg, 46Rh, and 46Ri may be adjacent to a second long side (e.g., right side) of the extension board 59 and may be electrically connected to the extension board 59 through a plurality of second connectors 46Rz.

The plurality of light sources 51 may be arranged in a matrix on the front surface of the plurality of substrates 46. The reflective sheet(s) 60 (see FIG. 2) may have holes in which the light sources 51 or the lenses covering the light sources 51 are disposed.

Accordingly, the extension board 59 may be electrically connected to the plurality of substrates 46 through the plurality of connectors 46Lz and 46Rz. The LED driver P2 may be electrically connected to a connector of the extension board 59 through a cable Fi (see FIG. 32). The cable Fi may be a Flexible Flat Cable (FFC). The connectivity of the LED driver P2 may be expanded to the plurality of substrates 46 through the extension board 59.

Each of the plurality of substrates 46 is connected to the extension board 59 through each of the plurality of connectors 46Lz and 46Rz, such that local dimming blocks may be formed independently on each of the plurality of substrates 46. The light sources 51, mounted on each of the plurality of substrates 46, may be arranged in several lines along the plurality of legs 46Ln; 46Rn. In other words, the light sources 51 mounted on each of the plurality of substrates 46 may be arranged in two lines in a longitudinal direction of the substrate 46 and may be sequentially grouped into local dimming blocks in the longitudinal direction of the substrate 46. In this case, some of the light sources 51 may be arranged in a line along the body 46L0; 46R0, and the remaining light sources 51 may be arranged in a line on each of the plurality of legs 46Ln; 46Rn.

For example, 40 light sources 51 may be arranged in two lines along the first substrate 46La, and the light sources 51 in two lines may be grouped by N number into local diming blocks. Here, N is an even number greater than or equal to 2, and if the light sources 51 in two lines are grouped by fours into local dimming blocks, the number of local dimming blocks BL1, BL2, BL3, BL4, BL5, BL6, BL7, BL8, BL9, and BL10 is ten. The local dimming blocks of the first substrate 46La may be formed independently of the local dimming blocks of each of the remaining first substrates 46Lb, 46Lc, 46Ld, 46Le, 46Lf, 46Lg, 46Lh, 46Li, and may also be formed independently of the local dimming blocks of each of the plurality of second substrates 46Ra, 46Rb, 46Rc, 46Rd, 46Re, 46Rf, 46Rg, 46Rh, and 46Ri.

Accordingly, the structure described above with reference to FIGS. 22 and 23 may achieve a better local dimming effect than the structure described above with reference to FIG. 15. Further, in the structure described above with reference to FIGS. 22 and 23, each of the plurality of connectors 46Lz and 46Rz merely has a power source and the same number of pins as the number of local dimming blocks, without further including the input and output connectors of FIG. 16. In addition, in the case where the light sources 51 have the same pitch, a width 46w of the body of the substrate 46 of FIGS. 22 and 23 may be equal to the width 43w of the substrate 43 of FIG. 15.

Meanwhile, a horizontal pitch Dx of the light sources 51 may be equal or similar to a vertical pitch Dy of the light sources 51. For example, the horizontal pitch Dx may be smaller than the vertical pitch Dy. In this case, a direction in which the horizontal pitch Dx is defined may be parallel to the long sides LS1 and L2 (see FIG. 1) of the display device 1, a direction in which the vertical pitch Dy is defined may be parallel to the short sides SS1 and SS2 (see FIG. 1) of the display device 1. The number of light sources arranged in the long-side direction of the display device 1 may be greater than the number of light sources arranged in the short-side direction of the display device 1.

Referring to FIG. 23, a first substrate 46L may have the same shape as a second substrate 46R. The first substrate 46L may have a body 46L0 and a plurality of legs 46Ln, and the second substrate 46R may have a body 46R0 and a plurality of legs 46Rn. A gap 46g between the plurality of legs 46Ln; 46Rn may be equal to a width 46t of each of the plurality of legs 46Ln; 46Rn. The gap 46g may be a width of a groove. Before the first substrate 46L and the second substrate 46R are separated from each other, first, second, third, fourth, fifth, sixth, seventh, eighth, ninth, tenth, eleventh, twelfth, thirteenth, fourteenth, fifteenth, sixteenth, seventeenth, eighteenth, nineteenth, and twentieth legs 46L1, 46L2, 46L3, 46L4, 46L5, 46L6, 46L7, 46L8, 46L9, 46L10, 46L11, 46L12, 46L13, 46L14, 46L15, 46L16, 46L17, 46L18, 46L19, and 46L20 of the first substrate 46L may be arranged alternately with first, second, third, fourth, fifth, sixth, seventh, eighth, ninth, tenth, eleventh, twelfth, thirteenth, fourteenth, fifteenth, sixteenth, seventeenth, eighteenth, nineteenth, and twentieth legs 46R1, 46R2, 46R3, 46R4, 46R5, 46R6, 46R7, 46R8, 46R9, 46R10, 46R11, 46R12, 46R13, 46R14, 46R15, 46R16, 46R17, 46R18, 46R19, 46R20 of the second substrate 46R.

A single plate 46A may be cut by a cutting process to be divided into the plurality of first substrates 46L and the plurality of second substrates 46R, and a remaining portion of the plate 46A, other than the substrates 46L and 46R, may be much smaller than the area of the cut-out substrates 46L and 46R. Accordingly, manufacturing costs of the substrates 46L and 46R may be greatly reduced.

A first connector 46Lz may be connected to a leg, disposed at one end in a longitudinal direction of the first substrate 46L, among the plurality of legs 46Ln of the first substrate 46L. For example, the first connector 46Lz may be coupled to the twentieth leg 46L20, and the leg to which the first connector 46Lz is coupled may be referred to as a mounting leg. A width 46tm of the twentieth leg 46L20 as the mounting leg is greater than or equal to the width 46t (see FIG. 22) of the remaining legs.

A second connector 46Rz may be connected to a leg, disposed at one end in a longitudinal direction of the second substrate 46R, among the plurality of legs 46Rn of the second substrate 46R. For example, the second connector 46Rz may be coupled to the twentieth leg 46R20, and the leg to which the second connector 46Rz is coupled may be referred to as a mounting leg. A width 46tm of the twentieth leg 46R20 as the mounting leg is greater than or equal to the width 46t (see FIG. 22) of the remaining legs.

Referring to FIGS. 23 to 27, at least two light sources 51 may be arranged along each of the plurality of legs 46Ln. The above and the following description of the light sources 51 and the legs 46Ln may also be applied to the light sources 51 and the legs 46Rn.

Referring to FIG. 23, a pair of light sources 51 may be mounted on the second leg 46L2 and a region of the body 46L0 that corresponds to the second leg 46L2. The light sources 51 mounted on the body 46L0 may be in contact with a boundary line Bt between the body 46L0 and the second leg 46L2 or may be spaced apart from the boundary line.

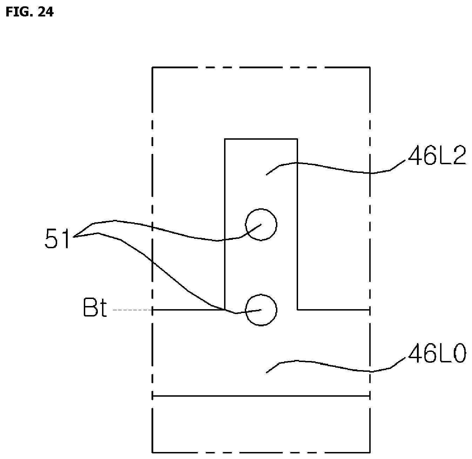

Referring to FIG. 24, a pair of light sources 51 may be mounted on the second leg 46L2 and a region of the body 46L0 that corresponds to the second leg 46L2. The light sources 51 mounted on the body 46L0 may intersect a boundary line Bt between the body 46L0 and the second leg 46L2.

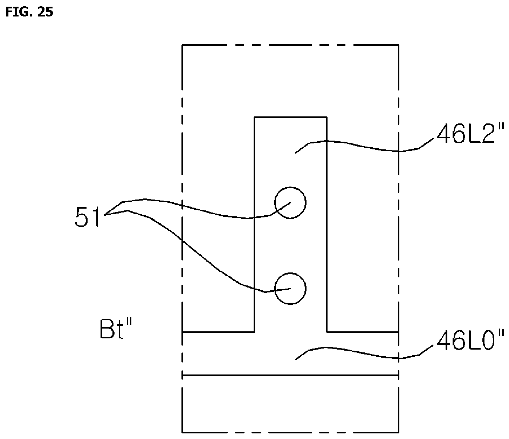

Referring to FIG. 25, a pair of light sources 51 may be mounted on a second leg 46L2". Any one of the plurality of light sources 51 may be in contact with a boundary line Bt" between a body 46L0" and the second leg 46L2" or may be spaced apart from the boundary line. The number of light sources 51 on the second leg 46L2" may be two or three or more.

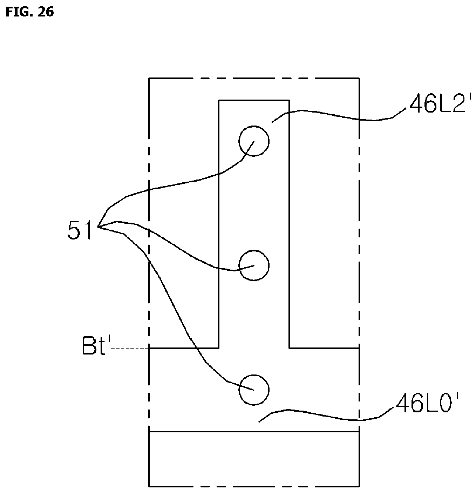

Referring to FIG. 26, a plurality of light sources 51 may be mounted on the second leg 46L2' and a region of the body 46L0' that corresponds to the second leg 46L2'. The number of light sources 51 on the second leg 46L2' may be two or three or more. The light sources 51 mounted on the body 46L0 may be in contact with a boundary line Bt' between the body 46L0' and the second leg 46L2', or may intersect or may be spaced apart from the boundary line. Alternatively, two or more light sources 51 may be mounted on the body 46L0.

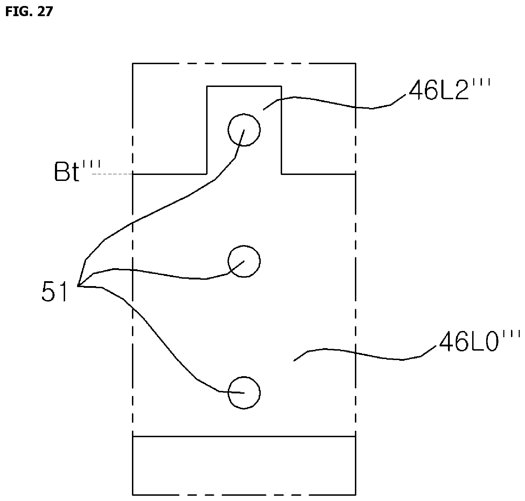

Referring to FIG. 27, a plurality of light sources 51 may be mounted on a second leg 46L2‴ and a region of the body 46L0‴ that corresponds to the second leg 46L2"'. The number of light sources 51 on the second leg 46L2' may be two or three or more. Any one of the light sources 51 mounted on the body 46L0‴ may be in contact with a boundary line Bt‴ between the body 46L0‴ and the second leg 46L2"', or may intersect or may be spaced apart from the boundary line. The light sources 51 on the second leg 46L2‴ may be in contact with a boundary line Bt‴ between the body 46L0‴ and the second leg 46L2‴ or may be spaced apart from the boundary line. Alternatively, two or more light sources 51 may be mounted on the second leg 46L2"'.

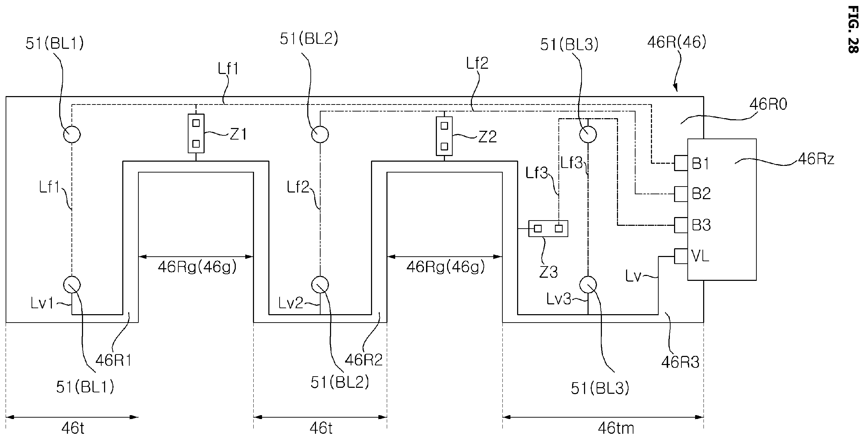

Referring to FIG. 28, the arrangement of wires and components on the substrate 46 will be described using the second substate 46R as an example. The light sources 51 may be mounted on the first leg 46R1 and the body 46R0 in a longitudinal direction of the first leg 46R1. The light sources 51 may be mounted on the second leg 46R2 and the body 46R0 in a longitudinal direction of the second leg 46R2. The light sources 51 may be mounted on the third leg 46R3 and the body 46R0 in a longitudinal direction of the third leg 46R3. Lines Lv, Lf1, Lf2, and Lf3 which will be described below may be circuits.

A power line Lv (shown by a solid line) may be connected to the power VL of the second connector 46Rz, and may be wired to the legs 46R1, 46R2, and 46R3 through the body 46R0. The power line Lv may be adjacent to a lower side of the second substrate 46R and may be disposed along the lower side, and the lines Lf1, Lf2, and Lf3 nay be opposite to the power line Lv with respect to the light sources 51. Some of the lines Lf1, Lf2, and Lf3 may be adjacent to an upper side of the second substrate 46R and may be arranged along the upper side. The power line Lv may branch into a number corresponding to the number of local dimming blocks. A first branch line Lv1 may be connected to the light sources 51 of the first leg 46R1 which are in the first local dimming block BL1. A second branch line Lv2 may be connected to the light sources 51 of the second leg 46R2 which are in the second local dimming block BL2. A third branch line Lv3 may be connected to the light sources 51 of the third leg 46R3 which are in the third local dimming block BL3.

A first line Lf1 (shown by a dotted line) may be connected to the first branch line Lv1 and may pass through the light sources 51 of the body 46R0, which are in the first local dimming block BL1, to be connected to the first pin B1 of the second connector 46Rz. A portion of the first line Lf1 may extend along the first leg 46R1 and may connect the light sources 51 included in the first local diming block BL1. Other portion of the first line Lf1 may extend along the upper side of the second substrate 46R and may be connected to the first pin B1.

A second line Lf2 (shown by a two-dot-dashed line) may be connected to the second branch line Lv2 and may pass through the light sources 51 of the body 46R0, which are in the second local dimming block BL2, to be connected to the second pin B2 of the second connector 46Rz. A portion of the second line Lf2 may extend along the second leg 46R2 and may connect the light sources 51 included in the second local diming block BL2. Other portion of the second line Lf2 may extend along the upper side of the second substrate 46R and may be connected to the second pin B2.

A third line Lf3 (shown by a one-dot-dashed line) may be connected to the third branch line Lv3 and may pass through the light sources 51 of the body 46R0, which are in the third local dimming block BL3, to be connected to the third pin B3 of the second connector 46Rz. A portion of the third line Lf3 may extend along the third leg 46R3 and may connect the light sources 51 included in the third local diming block BL3. Other portion of the third line Lf3 may extend along the upper side of the second substrate 46R and may be connected to the third pin B3.

The above power VL may be power VLED supplied from the power supply board P1 to the second connector 46Rz through the LED driver P2 and the extension board 59 (see FIG. 32). The pins B1, B2, and B3 of the second connector 46Rz described above may be connected to the driver IC of the extension board 59 (see FIG. 22). The above lines Lf1, Lf2, and Lf3 may be referred to as feedback lines Lf1, Lf2, and Lf3.

The power VL may be supplied to the first local dimming block BL1 through the first branch line Lv1, and a current having passed through the first local dimming block BL1 may flow to the driver IC through the first line Lf1 and the first pin B1. Likewise, the power VL may be supplied to each of the second and third local dimming blocks BL2 and BL3 through the second and third branch lines Lv2 and Lv3, respectively, and a current having passed through each of the second and third local dimming blocks BL2 and BL3 may flow to the driver IC through each of the second and third lines Lf2 and Lf3 and each of the second and third pins B2 and B3. In this case, the driver IC may control the brightness of the light sources 51, included in the respective local dimming blocks BL1, BL2, and BL3, by adjusting the amount of current flowing through the light sources 51 which are included in the respective local dimming blocks BL1, BL2, and BL3, or by blocking the flow of current, and as a result may implement local dimming.

In this case, each of the local dimming blocks BL1, BL2, and BL3 may include a pair of light sources 51 arranged along the respective legs 46R1, 46R2, and 46R3.

Diodes Z1, Z2, and Z3 may be mounted between the local dimming blocks BL1, BL2, and BL3 and may be mounted on the substrate 46. The diodes Z1, Z2, and Z3 may be ESD Protection Diodes for preventing electrostatic discharge (ESD). The diodes Z1, Z2, and Z3 may be Zener diodes.

A first diode Z1 may be disposed between the first local dimming block BL1 and the second local dimming block BL2, and may be mounted on the body 46R0. That is, the first diode Z1 may be disposed between the first leg 46R1 and the second leg 46R2. One side of the first diode Z1 may be connected to a voltage line Lv between the first branch line Lv1 and the second branch line Lv2, and another side of the first diode Z1 may be connected to the first line Lf1.

A second diode Z2 may be disposed between the second local dimming block BL2 and the third local dimming block BL3, and may be mounted on the body 46R0. That is, the second diode Z2 may be disposed between the second leg 46R2 and the third leg 46R3. One side of the second diode Z2 may be connected to a voltage line Lv between the second branch line Lv3 and the third branch line Lv3, and another side of the second diode Z2 may be connected to the second line Lf2.

A third diode Z3 may be adjacent to the third local dimming block BL3, and may be mounted on the body 46R0 or the third leg 46R3. That is, the third diode Z3 may be adjacent to the third leg 46R3. One side of the third diode Z3 may be adjacent to the third branch line Lv3 and may be connected to a voltage line Lv, and another side of the third diode Z3 may be connected to the third line Lf3. The third leg 46R3 may be a mounting leg to which the second connector 46Rz is coupled, and the width 46tm of the third leg 46R3 is greater than the width 46t of the remaining legs 46R1 and 46R2.

In this case, the diodes Z1, Z2, and Z3 may be distributed over the substrate 46. Accordingly, lifting of the reflective sheet 60 (see FIG. 2) on the substrate 46 due to the diodes Z1, Z2, and Z3 may be minimized, thereby improving image quality. In addition, circuits may be mounted on the substrate 46 in a simple manner, requiring no jumpers and facilitating heat dissipation. Furthermore, the reflective sheet 60 may have cut-lines (see CLb of FIG. 8) which correspond to the diodes Z1, Z2, and Z3 and are opened by the diodes Z1, Z2, and Z3, in which case the reflective sheet 60 may be closer to the substrate 46.

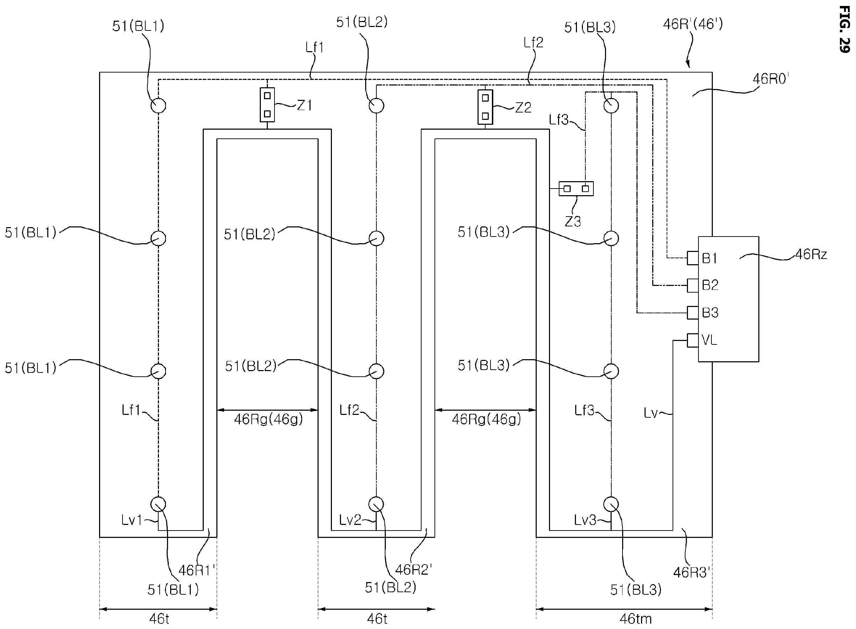

Referring to FIG. 29, the arrangement of wires and components on a substrate 46' will be described using a second substate 46R' as an example. The light sources 51 may be mounted on a first leg 46R1' and a body 46R0' in a longitudinal direction of the first leg 46R1'. The light sources 51 may be mounted on a second leg 46R2' and the body 46R0' in a longitudinal direction of the second leg 46R2'. The light sources 51 may be mounted on a third leg 46R3' and the body 46R0' in a longitudinal direction of the third leg 46R3'. Lines Lv, Lf1, Lf2, and Lf3 which will be described below may be circuits.

A power line Lv (shown by a solid line) may be connected to the power VL of the second connector 46Rz, and may be wired to the legs 46R1', 46R2', and 46R3' through the body 46R0'. The power line Lv may be adjacent to a lower side of the second substrate 46R' and may be disposed along the lower side, and the lines Lf1, Lf2, and Lf3 nay be opposite to the power line Lv with respect to the light sources 51. Some of the lines Lf1, Lf2, and Lf3 may be adjacent to an upper side of the second substrate 46R' and may be disposed along the upper side. The power line Lv may branch into a number corresponding to the number of local dimming blocks. A first branch line Lv1 may be connected to the light sources 51 of the first leg 46R1' which are in the first local dimming block BL1. A second branch line Lv2 may be connected to the light sources 51 of the second leg 46R2' included in the second local dimming block BL2. A third branch line Lv3 may be connected to the light sources 51 of the third leg 46R3' included in the third local dimming block BL3.

A first line Lf1 (shown by a dotted line) may be connected to the first branch line Lv1 and may pass through the light sources 51 of the first leg 46R1' and the body 46R0', which are included in the first local dimming block BL1, to be connected to the first pin B1 of the second connector 46Rz. A portion of the first line Lf1 may extend along the first leg 46R1' and may connect the light sources 51 included in the first local diming block BL1. Other portion of the first line Lf1 may extend along the upper side of the second substrate 46R' and may be connected to the first pin B1.

A second line Lf2 (shown by a two-dot-dashed line) may be connected to the second branch line Lv2 and may pass through the light sources 51 of the second leg 46R2' and the body 46R0', which are included in the second local dimming block BL2, to be connected to the second pin B2 of the second connector 46Rz. A portion of the second line Lf2 may extend along the second leg 46R2' and may connect the light sources 51 included in the second local diming block BL2. Other portion of the second line Lf2 may extend along the upper side of the second substrate 46R' and may be connected to the second pin B2.

A third line Lf3 (shown by a one-dot-dashed line) may be connected to the third branch line Lv3 and may pass through the light sources 51 of the third leg 46R3' and the body 46R0', which are included in the third local dimming block BL3, to be connected to the third pin B3 of the second connector 46Rz. A portion of the third line Lf3 may extend along the third leg 46R3' and may connect the light sources 51 included in the third local diming block BL3. Other portion of the third line Lf3 may extend along the upper side of the second substrate 46R' and may be connected to the third pin B3.

The above power VL may be power VLED supplied from the power supply board P1 to the second connector 46Rz through the LED driver P2 and the extension board 59 (see FIG. 32). The pins B1, B2, and B3 of the second connector 46Rz described above may be connected to the driver IC of the extension board 59 (see FIG. 22). The above lines Lf1, Lf2, and Lf3 may be referred to as feedback lines Lf1, Lf2, and Lf3.

The power VL may be supplied to the first local dimming block BL1 through the first branch line Lv1, and a current having passed through the first local dimming block BL1 may flow to the driver IC through the first line Lf1 and the first pin B1. Likewise, the power VL may be supplied to each of the second and third local dimming blocks BL2 and BL3 through the second and third branch lines Lv2 and Lv3, respectively, and a current having passed through each of the second and third local dimming blocks BL2 and BL3 may flow to the driver IC through each of the second and third lines Lf2 and Lf3 and each of the second and third pins B2 and B3. In this case, the driver IC may control the brightness of the light sources 51, included in the respective local dimming blocks BL1, BL2, and BL3, by adjusting the amount of current flowing through the light sources 51 which are included in the respective local dimming blocks BL1, BL2, and BL3, or by blocking the flow of current, and as a result may implement local dimming.

In this case, each of the local dimming blocks BL1, BL2, and BL3 may include a plurality of light sources 51 arranged along the respective legs 46R1, 46R2, and 46R3. The number of light sources 51 of each of the local dimming blocks BL1, BL2, and BL3 may be two, three, or four or more.

Diodes Z1, Z2, and Z3 may be mounted between the local dimming blocks BL1, BL2, and BL3 and may be mounted on the substrate 46'. The diodes Z1, Z2, and Z3 may be ESD Protection Diodes for preventing electrostatic discharge (ESD). The diodes Z1, Z2, and Z3 may be Zener diodes.

A first diode Z1 may be disposed between the first local dimming block BL1 and the second local dimming block BL2, and may be mounted on the body 46R0'. That is, the first diode Z1 may be disposed between the first leg 46R1' and the second leg 46R2'. One side of the first diode Z1 may be connected to a voltage line Lv between the first branch line Lv1 and the second branch line Lv2, and another side of the first diode Z1 may be connected to the first line Lf1.

A second diode Z2 may be disposed between the second local dimming block BL2 and the third local dimming block BL3, and may be mounted on the body 46R0'. That is, the second diode Z2 may be disposed between the second leg 46R2' and the third leg 46R3'. One side of the second diode Z2 may be connected to a voltage line Lv between the second branch line Lv3 and the third branch line Lv3, and another side of the second diode Z2 may be connected to the second line Lf2.

A third diode Z3 may be adjacent to the third local dimming block BL3, and may be mounted on the body 46R0' or the third leg 46R3'. That is, the third diode Z3 may be adjacent to the third leg 46R3'. One side of the third diode Z3 may be adjacent to the third branch line Lv3 and may be connected to a voltage line Lv, and another side of the third diode Z3 may be connected to the third line Lf3. The third leg 46R3' may be a mounting leg to which the second connector 46Rz is coupled, and the width 46tm of the third leg 46R3' is greater than the width 46t of the remaining legs 46R1' and 46R2'.

In this case, the diodes Z1, Z2, and Z3 may be distributed over the substrate 46'. Accordingly, lifting of the reflective sheet 60 (see FIG. 2) on the substrate 46' due to the diodes Z1, Z2, and Z3 may be minimized, thereby improving image quality. In addition, circuits may be mounted on the substrate 46' in a simple manner, requiring no jumpers and facilitating heat dissipation. Furthermore, the reflective sheet 60 may have cut-lines (see CLb of FIG. 8) which correspond to the diodes Z1, Z2, and Z3 and are opened by the diodes Z1, Z2, and Z3, in which case the reflective sheet 60 may be closer to the substrate 46'.

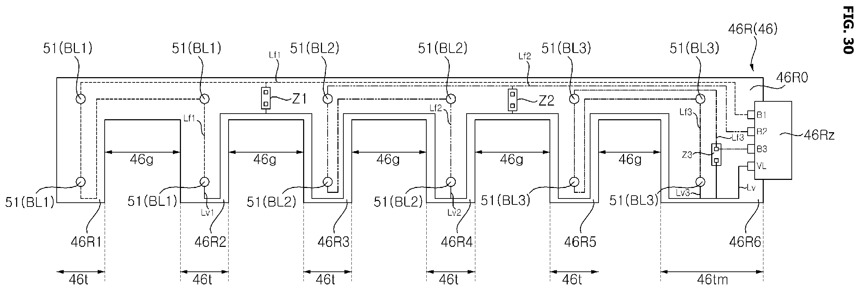

Referring to FIG. 30, the arrangement of wires and components on the substrate 46 will be described using the second substate 46R as an example. The light sources 51 may be mounted on the first leg 46R1 and the body 46R0 in a longitudinal direction of the first leg 46R1. The light sources 51 may be mounted on the second leg 46R2 and the body 46R0 in a longitudinal direction of the second leg 46R2. The light sources 51 may be mounted on the third leg 46R3 and the body 46R0 in a longitudinal direction of the third leg 46R3. The light sources 51 may be mounted on the fourth leg 46R4 and the body 46R0 in a longitudinal direction of the fourth leg 46R4. The light sources 51 may be mounted on the fifth leg 46R5 and the body 46R0 in a longitudinal direction of the fifth leg 46R5. The light sources 51 may be mounted on the sixth leg 46R6 and the body 46R0 in a longitudinal direction of the sixth leg 46R6. Lines Lv, Lf1, Lf2, and Lf3 which will be described below may be circuits.

A power line Lv (shown by a solid line) may be connected to the power VL of the second connector 46Rz, and may be wired to the legs 46R1, 46R2, 46R3, 46R4, 46R5, and 46R6 through the body 46R0. The power line Lv may be adjacent to a lower side of the second substrate 46R and may be disposed along the lower side, and the lines Lf1, Lf2, and Lf3 nay be opposite to the power line Lv with respect to the light sources 51. Some of the lines Lf1, Lf2, and Lf3 may be adjacent to an upper side of the second substrate 46R and may be disposed along the upper side. The power line Lv may branch into a number corresponding to the number of local dimming blocks. A first branch line Lv1 may be connected to the light sources 51 of the second leg 46R2 which are in the first local dimming block BL1. A second branch line Lv2 may be connected to the light sources 51 of the fourth leg 46R4 which are in the second local dimming block BL2. A third branch line Lv3 may be connected to the light sources 51 of the sixth leg 46R6 which are included in the third local dimming block BL3.

A first line Lf1 (shown by a dotted line) may be connected to the first branch line Lv1 and may pass through the light sources 51 of the body 46R0 and the first leg 46R1, which are included in the first local dimming block BL1, to be connected to the first pin B1 of the second connector 46Rz. A portion of the first line Lf1 may extend along the second leg 46R2, the body 46R0, and the first leg 46R1 and may connect the light sources 51 included in the first local diming block BL1. Other portion of the first line Lf1 may extend along the upper side of the second substrate 46R and may be connected to the first pin B1.

A second line Lf2 (shown by a two-dot-dashed line) may be connected to the second branch line Lv2 and may pass through the light sources 51 of the body 46R0 and the third leg 46R3, which are included in the second local dimming block BL2, to be connected to the second pin B2 of the second connector 46Rz. A portion of the second line Lf2 may extend along the fourth leg 46R4, the body 46R0, and the third leg 46R3, and may connect the light sources 51 included in the second local diming block BL2. Other portion of the second line Lf2 may extend along the upper side of the second substrate 46R and may be connected to the second pin B2.

A third line Lf3 (shown by a one-dot-dashed line) may be connected to the third branch line Lv3 and may pass through the light sources 51 of the body 46R0 and the fifth leg 46R5, which are included in the third local dimming block BL3, to be connected to the third pin B3 of the second connector 46Rz. A portion of the third line Lf3 may extend along the sixth leg 46R6, the body 46R0, and the fifth leg 46R5, and may connect the light sources 51 included in the third local diming block BL3. Other portion of the third line Lf3 may extend along the upper side of the second substrate 46R and may be connected to the third pin B3.

The above power VL may be power VLED supplied from the power supply board P1 to the second connector 46Rz through the LED driver P2 and the extension board 59 (see FIG. 32). The pins B1, B2, and B3 of the second connector 46Rz described above may be connected to the driver IC of the extension board 59 (see FIG. 22). The above lines Lf1, Lf2, and Lf3 may be referred to as feedback lines Lf1, Lf2, and Lf3.

The power VL may be supplied to the first local dimming block BL1 through the first branch line Lv1, and a current having passed through the first local dimming block BL1 may flow to the driver IC through the first line Lf1 and the first pin B1. Likewise, the power VL may be supplied to each of the second and third local dimming blocks BL2 and BL3 through the second and third branch lines Lv2 and Lv3, respectively, and a current having passed through each of the second and third local dimming blocks BL2 and BL3 may flow to the driver IC through each of the second and third lines Lf2 and Lf3 and each of the second and third pins B2 and B3. In this case, the driver IC may control the brightness of the light sources 51, included in the respective local dimming blocks BL1, BL2, and BL3, by adjusting the amount of current flowing through the light sources 51 which are included in the respective local dimming blocks BL1, BL2, and BL3, or by blocking the flow of current, and as a result may implement local dimming.

In this case, each of the local dimming blocks BL1, BL2, and BL3 may include four light sources 51 arranged along two legs 46R1, 46R2; 46R3, 46R4; 46R5, 46R6.

Diodes Z1, Z2, and Z3 may be mounted between the local dimming blocks BL1, BL2, and BL3 and may be mounted on the substrate 46. The diodes Z1, Z2, and Z3 may be ESD Protection Diodes for preventing electrostatic discharge (ESD). The diodes Z1, Z2, and Z3 may be Zener diodes.

A first diode Z1 may be disposed between the first local dimming block BL1 and the second local dimming block BL2, and may be mounted on the body 46R0. That is, the first diode Z1 may be disposed between the second leg 46R2 and the third leg 46R3. One side of the first diode Z1 may be connected to a voltage line Lv between the first branch line Lv1 and the second branch line Lv2, and another side of the first diode Z1 may be connected to the first line Lf1.

A second diode Z2 may be disposed between the second local dimming block BL2 and the third local dimming block BL3, and may be mounted on the body 46R0. That is, the second diode Z2 may be disposed between the fourth leg 46R4 and the fifth leg 46R5. One side of the second diode Z2 may be connected to a voltage line Lv between the second branch line Lv3 and the third branch line Lv3, and another side of the second diode Z2 may be connected to the second line Lf2.

A third diode Z3 may be adjacent to the third local dimming block BL3, and may be mounted on the body 46R0 or the sixth leg 46R6. That is, the third diode Z3 may be adjacent to the sixth leg 46R6. One side of the third diode Z3 may be adjacent to the third branch line Lv3 and may be connected to a voltage line Lv, and another side of the third diode Z3 may be connected to the third line Lf3. The sixth leg 46R6 may be a mounting leg to which the second connector 46Rz is coupled, and the width 46tm of the sixth leg 46R6 is greater than the width 46t of the remaining legs 46R1, 46R2, 46R3, 46R4, and 46R5.

In this case, the diodes Z1, Z2, and Z3 may be distributed over the substrate 46. Accordingly, lifting may be minimized of the reflective sheet 60 (see FIG. 2) on the substrate 46 due to the diodes Z1, Z2, and Z3, thereby improving image quality. In addition, circuits may be mounted on the substrate 46 in a simple manner, requiring no jumpers and facilitating heat dissipation. Furthermore, the reflective sheet 60 may have cut-lines (see CLb of FIG. 8) which correspond to the diodes Z1, Z2, and Z3 and are opened by the diodes Z1, Z2, and Z3, in which case the reflective sheet 60 may be closer to the substrate 46.

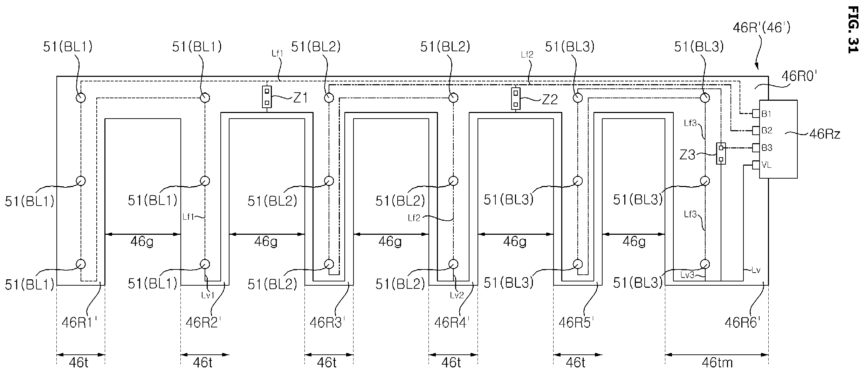

Referring to FIG. 31, the arrangement of wires and components on the substrate 46' will be described using the second substate 46R' as an example. The light sources 51 may be mounted on the first leg 46R1' and the body 46R0' in a longitudinal direction of the first leg 46R1'. The light sources 51 may be mounted on the second leg 46R2' and the body 46R0' in a longitudinal direction of the second leg 46R2'. The light sources 51 may be mounted on the third leg 46R3' and the body 46R0' in a longitudinal direction of the third leg 46R3'. The light sources 51 may be mounted on the fourth leg 46R4' and the body 46R0' in a longitudinal direction of the fourth leg 46R4'. The light sources 51 may be mounted on the fifth leg 46R5' and the body 46R0' in a longitudinal direction of the fifth leg 46R5'. The light sources 51 may be mounted on the sixth leg 46R6' and the body 46R0' in a longitudinal direction of the sixth leg 46R6'. Lines Lv, Lf1, Lf2, and Lf3 which will be described below may be circuits.

A power line Lv (shown by a solid line) may be connected to the power VL of the second connector 46Rz, and may be wired to the legs 46R1', 46R2', 46R3', 46R4', 46R5', and 46R6' through the body 46R0'. The power line Lv may be adjacent to a lower side of the second substrate 46R' and may be disposed along the lower side, and the lines Lf1, Lf2, and Lf3 nay be opposite to the power line Lv with respect to the light sources 51. Some of the lines Lf1, Lf2, and Lf3 may be adjacent to an upper side of the second substrate 46R' and may be disposed along the upper side. The power line Lv may branch into a number corresponding to the number of local dimming blocks. A first branch line Lv1 may be connected to the light sources 51 of the second leg 46R2' which are included in the first local dimming block BL1. A second branch line Lv2 may be connected to the light sources 51 of the fourth leg 46R4' which are included in the second local dimming block BL2. A third branch line Lv3 may be connected to the light sources 51 of the sixth leg 46R6' which are included in the third local dimming block BL3.

A first line Lf1 (shown by a dotted line) may be connected to the first branch line Lv1 and may pass through the light sources 51 of the second leg 46R2', the body 46R0', and the first leg 46R1', which are included in the first local dimming block BL1, to be connected to the first pin B1 of the second connector 46Rz. A portion of the first line Lf1 may extend along the second leg 46R2', the body 46R0', and the first leg 46R1', and may connect the light sources 51 included in the first local diming block BL1. Other portion of the first line Lf1 may extend along the upper side of the second substrate 46R' and may be connected to the first pin B1.

A second line Lf2 (shown by a two-dot-dashed line) may be connected to the second branch line Lv2 and may pass through the light sources 51 of the fourth leg 46R4', the body 46R0', and the third leg 46R3', which are included in the second local dimming block BL2, to be connected to the second pin B2 of the second connector 46Rz. A portion of the second line Lf2 may extend along the fourth leg 46R4', the body 46R0', and the third leg 46R3', and may connect the light sources 51 included in the second local diming block BL2. Other portion of the second line Lf2 may extend along the upper side of the second substrate 46R' and may be connected to the second pin B2.

A third line Lf3 (shown by a one-dot-dashed line) may be connected to the third branch line Lv3 and may pass through the light sources 51 of the sixth leg 46R6', the body 46R0', and the fifth leg 46R5', which are included in the third local dimming block BL3, to be connected to the third pin B3 of the second connector 46Rz. A portion of the third line Lf3 may extend along the sixth leg 46R6', the body 46R0', and the fifth leg 46R5', and may connect the light sources 51 included in the third local diming block BL3. Other portion of the third line Lf3 may extend along the upper side of the second substrate 46R' and may be connected to the third pin B3.

The above power VL may be power VLED supplied from the power supply board P1 to the second connector 46Rz through the LED driver P2 and the extension board 59 (see FIG. 32). The pins B1, B2, and B3 of the second connector 46Rz described above may be connected to the driver IC of the extension board 59 (see FIG. 22). The above lines Lf1, Lf2, and Lf3 may be referred to as feedback lines Lf1, Lf2, and Lf3.

The power VL may be supplied to the first local dimming block BL1 through the first branch line Lv1, and a current having passed through the first local dimming block BL1 may flow to the driver IC through the first line Lf1 and the first pin B1. Likewise, the power VL may be supplied to each of the second and third local dimming blocks BL2 and BL3 through the second and third branch lines Lv2 and Lv3, respectively, and a current having passed through each of the second and third local dimming blocks BL2 and BL3 may flow to the driver IC through each of the second and third lines Lf2 and Lf3 and each of the second and third pins B2 and B3. In this case, the driver IC may control the brightness of the light sources 51, included in the respective local dimming blocks BL1, BL2, and BL3, by adjusting the amount of current flowing through the light sources 51 which are included in the respective local dimming blocks BL1, BL2, and BL3, or by blocking the flow of current, and as a result may implement local dimming.

In this case, each of the local dimming blocks BL1, BL2, and BL3 may include M number of light sources 51 arranged along N number of legs 46R1', 46R2', 46R3', 46R4', 46R5', and 46R6'. Here, N is a natural number greater than or equal to 2, and M is a number obtained by multiplying the number of light sources, arranged along the respective legs, by N. For example, each of the local dimming blocks BL1, BL2, and BL3 may include six light sources 51 which are arranged along two legs 46R1', 46R2'; 46R3', 46R4'; 46R5', 46R6', in which three light sources may be arranged along the respective legs. In another example, each of the local dimming blocks BL1, BL2, and BL3 may include nine light sources 51 which are arranged along three legs 46R1', 46R2', 46R3'; 46R4', 46R5', 46R6', in which three light sources may be arranged along the respective legs.

Diodes Z1, Z2, and Z3 may be mounted between the local dimming blocks BL1, BL2, and BL3 and may be mounted on the substrate 46'. The diodes Z1, Z2, and Z3 may be ESD Protection Diodes for preventing electrostatic discharge (ESD). The diodes Z1, Z2, and Z3 may be Zener diodes.

A first diode Z1 may be disposed between the first local dimming block BL1 and the second local dimming block BL2, and may be mounted on the body 46R0'. That is, the first diode Z1 may be disposed between the second leg 46R2' and the third leg 46R3'. One side of the first diode Z1 may be connected to a voltage line Lv between the first branch line Lv1 and the second branch line Lv2, and another side of the first diode Z1 may be connected to the first line Lf1.

A second diode Z2 may be disposed between the second local dimming block BL2 and the third local dimming block BL3, and may be mounted on the body 46R0'. That is, the second diode Z2 may be disposed between the fourth leg 46R4' and the fifth leg 46R5'. One side of the second diode Z2 may be connected to a voltage line Lv between the second branch line Lv3 and the third branch line Lv3, and another side of the second diode Z2 may be connected to the second line Lf2.

A third diode Z3 may be adjacent to the third local dimming block BL3, and may be mounted on the body 46R0' or the sixth leg 46R6'. That is, the third diode Z3 may be adjacent to the sixth leg 46R6'. One side of the third diode Z3 may be adjacent to the third branch line Lv3 and may be connected to a voltage line Lv, and another side of the third diode Z3 may be connected to the third line Lf3. The sixth leg 46R6' may be a mounting leg to which the second connector 46Rz is coupled, and the width 46tm of the sixth leg 46R6' is greater than the width 46t of the remaining legs 46R1', 46R2', 46R3', 46R4', and 46R5'.

In this case, the diodes Z1, Z2, and Z3 may be distributed over the substrate 46'. Accordingly, lifting of the reflective sheet 60 (see FIG. 2) on the substrate 46' due to the diodes Z1, Z2, and Z3 may be minimized, thereby improving image quality. In addition, circuits may be mounted on the substrate 46' in a simple manner, requiring no jumpers and facilitating heat dissipation. Furthermore, the reflective sheet 60 may have cut-lines (see CLb of FIG. 8) which correspond to the diodes Z1, Z2, and Z3 and are opened by the diodes Z1, Z2, and Z3, in which case the reflective sheet 60 may be closer to the substrate 46'.

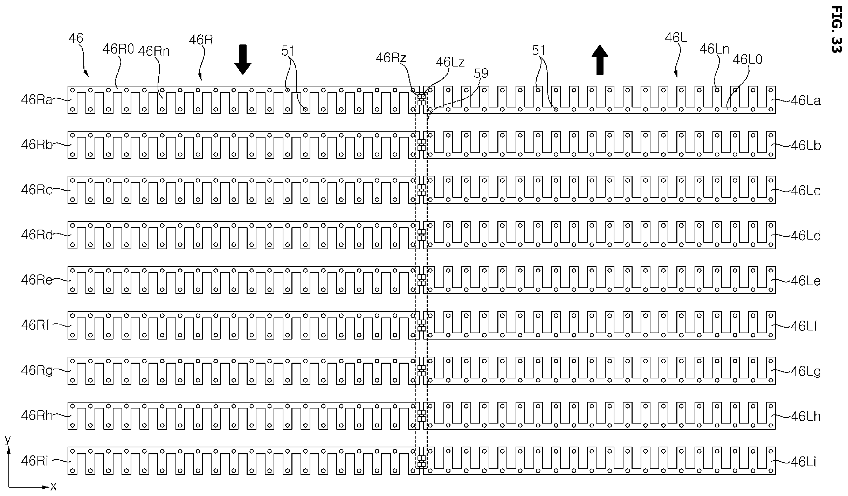

Referring to FIG. 32, the LED driver P2 may be connected to a connector of the extension board 59 through a cable Fi. The cable Fi may be connected to the connector of the extension board 59 through a hole 81i formed in the flat plate part 81 of the frame 80. The number of cables Fi may be equal to the number of extension boards 59. For example, one cable Fi may be connected to one extension board 59 of FIG. 22 (or FIGS. 33 to 38 which will be described below). The cable Fi may be a Flexible Flat Cable (FFC). A Micro Controller Unit (MCU) of the LED driver P2 may receive, from the main board P3, data about the brightness of a plurality of light sources 51 on a plurality of substrates 43; 44; 45; 46; 46' and may convert (process) the received data to the driver IC of the extension board 59 through the cable Fi. The driver IC may be connected to the substrates 43; 44; 45; 46; 46' through connectors 43Lz, 43Rz; 44Lz, 44Rz; 45Lz, 45Rz; 46Lz, 46Rz, and may control the brightness of the respective local dimming blocks by adjusting the amount of current flowing through the respective local dimming blocks or by blocking the flow of current.

Accordingly, the LED driver P2 may be simply connected to the plurality of substrates through the cable Fi and the extension board 59.

Referring to FIGS. 33 to 35, the extension board 59 may extend vertically. The plurality of first substrates 46L may be disposed at the left side of the extension board 59, and the plurality of second substrates 46R may be disposed at the right side of the extension board 59. A longitudinal axis of the extension board 59 may be parallel to a vertical line passing through the center of the display panel 10 (see FIG. 2). An area where the plurality of first substrates 46L are disposed may correspond to an area of the display panel 10 (see FIG. 2) which is located on the left side of the vertical line. An area where the plurality of second substrates 46R are disposed may correspond to an area of the display panel 10 (see FIG. 2) which is located on the right side of the vertical line.

Referring to FIG. 33, the plurality of legs 46Ln of each of the plurality of first substrates 46L may face upward relative to the body 46L0, and the plurality of legs 46Rn of each of the plurality of second substrates 46R may face downward relative to the body 46R0. Alternatively, the plurality of legs 46Ln of each of the plurality of first substrates 46L may face downward relative to the body 46L0, and the plurality of legs 46Rn of each of the plurality of second substrates 46R may face upward relative to the body 46R0. The plurality of first substrates 46L and the plurality of second substrates 46R may be point-symmetric with respect to a center point of the extension board 59.

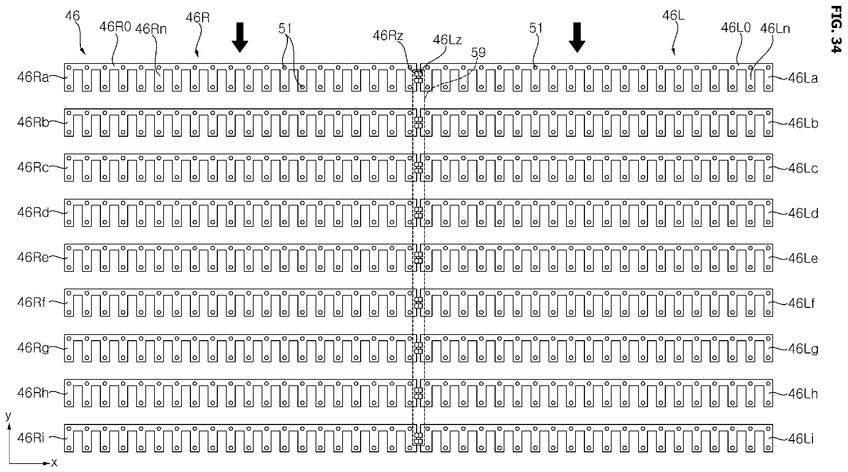

Referring to FIG. 34, the plurality of legs 46Ln of each of the plurality of first substrates 46L may face downward relative to the body 46L0, and the plurality of legs 46Rn of each of the plurality of second substrates 46R may face downward relative to the body 46R0. The plurality of first substrates 46L and the plurality of second substrates 46R may be line-symmetric with respect to the extension board 59.

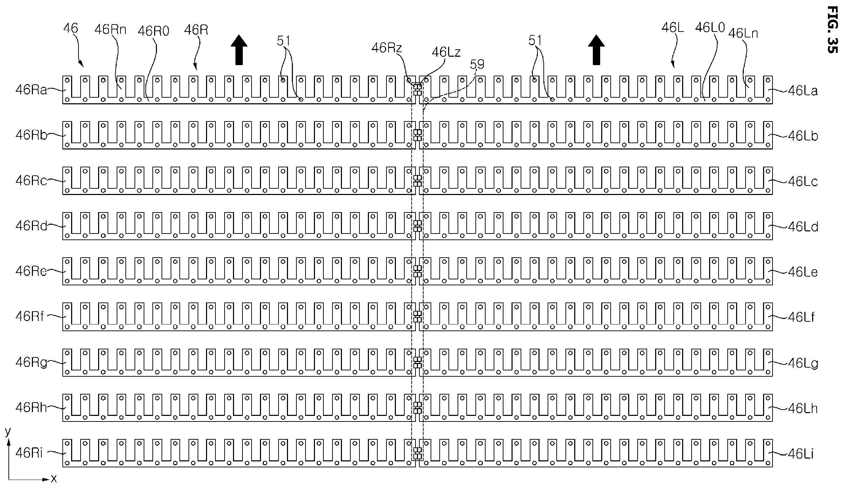

Referring to FIG. 35, the plurality of legs 46Ln of each of the plurality of first substrates 46L may face upward relative to the body 46L0, and the plurality of legs 46Rn of each of the plurality of second substrates 46R may face upward relative to the body 46R0. The plurality of first substrates 46L and the plurality of second substrates 46R may be line-symmetric with respect to the extension board 59.

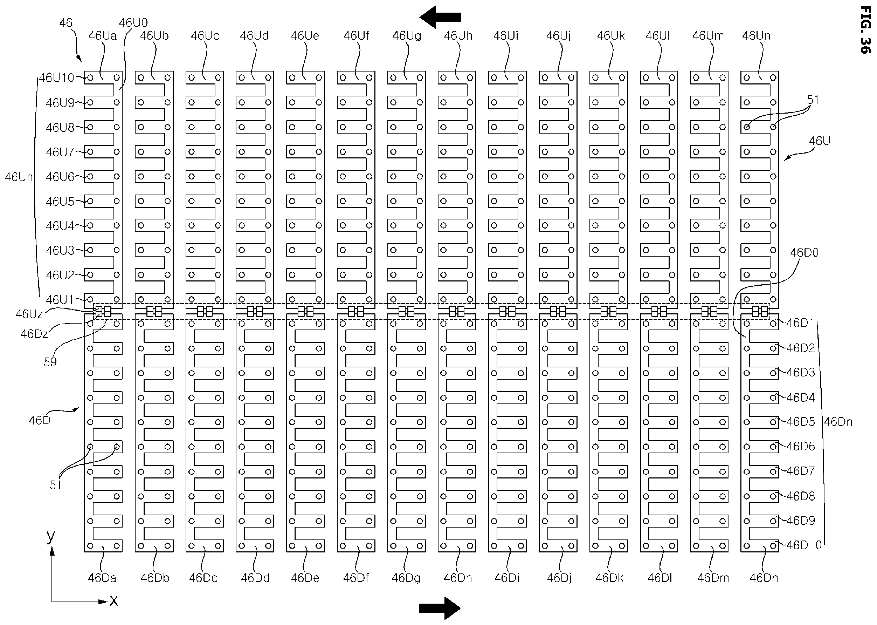

Referring to FIGS. 36 to 38, the extension board 59 may extend horizontally. A plurality of first substrates 46U may be disposed above the extension board 59, and a plurality of second substrates 46D may be disposed below the extension board 59. A longitudinal axis of the extension board 59 may be parallel to a horizontal line passing through the center of the display panel 10 (see FIG. 2). An area where the plurality of first substrates 46U are disposed may correspond to an area of the display panel 10 (see FIG. 2) which is located above the horizontal line. An area where the plurality of second substrates 46D are disposed may correspond to an area of the display panel 10 (see FIG. 2) which is located below the horizontal line.

Referring to FIG. 36, a plurality of legs 46Un of each of the plurality of first substrates 46U may face rightward relative to the body 46U0, and a plurality of legs 46Dn of each of the plurality of second substrates 46D may face leftward relative to the body 46U0. Alternatively, the plurality of legs 46Un of each of the plurality of first substrates 46U may face leftward relative to the body 46U0, and the plurality of legs 46Dn of each of the plurality of second substrates 46D may face rightward relative to the body 46U0. The plurality of first substrates 46U and the plurality of second substrates 46D may be point-symmetric with respect to a center point of the extension board 59.

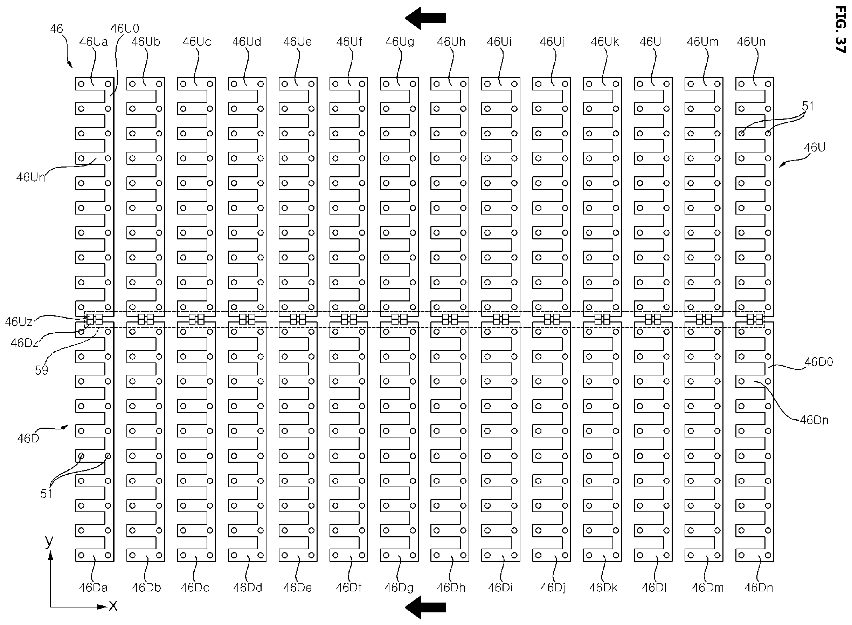

Referring to FIG. 37, the plurality of legs 46Un of each of the plurality of first substrates 46U may face rightward relative to the body 46U0, and the plurality of legs 46Dn of each of the plurality of second substrates 46D may face rightward relative to the body 46U0. The plurality of first substrates 46U and the plurality of second substrates 46D may be line-symmetric with respect to the extension board 59.

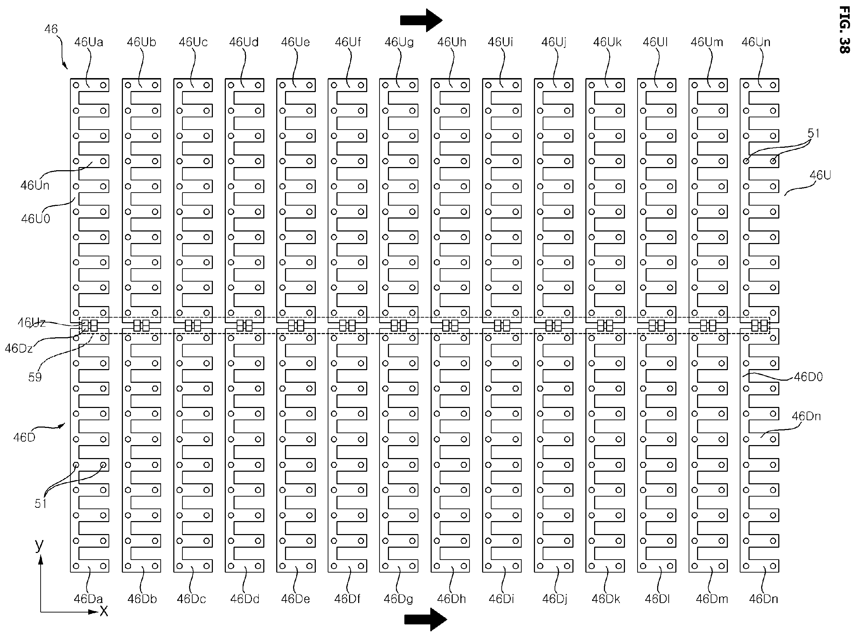

Referring to FIG. 38, the plurality of legs 46Un of each of the plurality of first substrates 46U may face leftward relative to the body 46U0, and the plurality of legs 46Dn of each of the plurality of second substrates 46D may face leftward relative to the body 46U0. The plurality of first substrates 46U and the plurality of second substrates 46D may be line-symmetric with respect to the extension board 59.

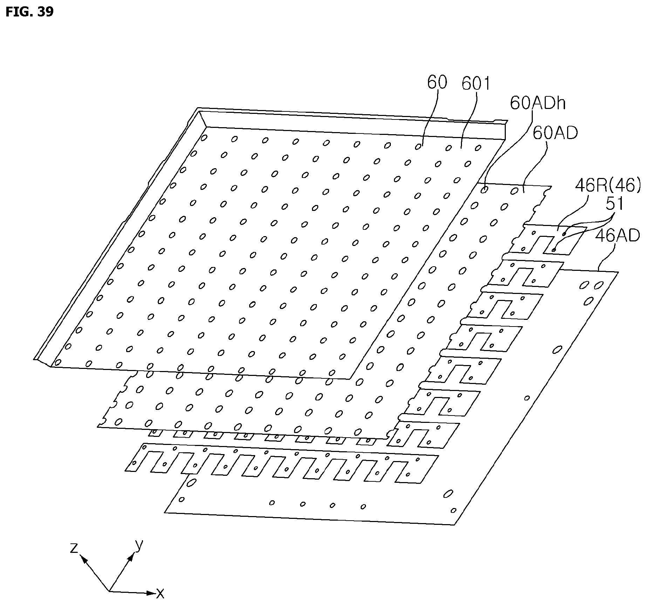

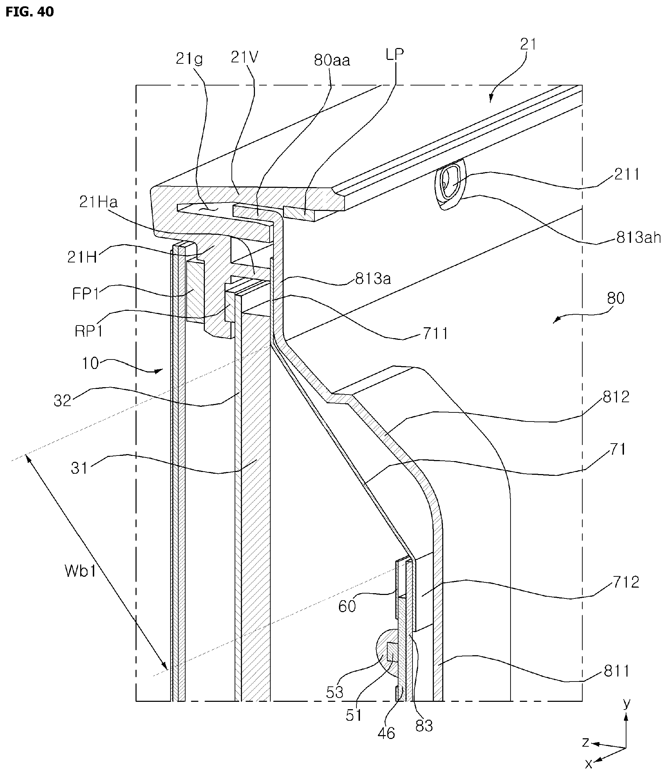

Referring to FIGS. 39 and 40, the rear surface of the substrate 46 may be bonded to the front surface of the frame 80 or the front surface of the heat sink 83 using an adhesive sheet 46AD. The adhesive sheet 46AD may be double-sided tape. The rear surface of the reflective sheet 60 may be bonded to the front surface of the substrate 46 using an adhesive sheet 60AD. The adhesive sheet 60AD may be double-sided tape. The light sources 51 on the substrate 46 may be disposed in holes 60ADh of the adhesive sheet 60AD and holes 601 of the reflective sheet 60.

Light from the light sources 51 may be provided to the display panel 10 through the diffusion plate 31 and the optical sheet 32. The lenses 53 may cover the light sources 51, may be coupled to the front surface of the substrate 46, and may be disposed in the holes 60ADh and 601. The lens 53 may include at least one of silicone, polymethyl methacrylate (PMMA), and polycarbonate (PC). The light from the light source 51 may be refracted or reflected by the lens 53, and thus may be spread with a wider beam angle than the light sources. The reflective sheet 60 may reflect light forward, which is provided from the light source 51 or reflected from the diffusion plate 31.

Meanwhile, the side frame 20 may include a first part 21, a second part 22, a third part 23, and a fourth part 24 (see FIG. 2). The first part 21 may extend along the upper side of the display panel 10, and the second part 22 may extend along the lower side of the display panel 10. The third part 23 may extend along the left side of the display panel 10, and the fourth part 24 may extend along the right side of the display panel 10. Each of the first to fourth parts 21, 22, 23, and 24 may include a vertical part and a horizontal part. A vertical part 21V of the first part 21 may cover the upper side of the display panel 10 and the upper side of the frame 80. A horizontal part 21H of the first part 21 may intersect the vertical part 21V and may be disposed between the display panel 10 and the optical sheet 32. A front pad FP1 may be bonded to the rear surface of the display panel 10 and the front surface of the horizontal part 21H. A rear pad RP1 may be bonded to the rear surface of the horizontal part 21H and the front surface of the optical sheet 32. Accordingly, the side frame 20 may protect the edges of the display panel 10.

Referring to FIGS. 1 to 40, a display device according to an aspect of the present disclosure may include: a display panel; a frame positioned behind the display panel; a substrate positioned between the display panel and the frame, and coupled to the frame; and a plurality of light sources positioned on the substrate; wherein the substrate may include: an elongated body; and legs protruding from one long side of the body, and spaced apart from each other along the one long side, wherein the plurality of light sources may include: a first row of light sources positioned on the legs; and a second row of light sources positioned on the legs or the body, the second row being spaced apart from the first row, wherein the first and second rows of light sources are disposed along columns parallel to the legs, and are grouped into a local dimming block for at least each one of the columns.

The local dimming block may be provided in plurality, and the display device may further include a plurality of diodes positioned between the plurality of local dimming blocks and positioned on the substrate.

The diodes may be a diode for preventing electrostatic discharge.

The plurality of diodes may be mounted on the body.

The display device may further include a reflective sheet positioned on the substate and having holes at which the plurality of light sources are positioned, wherein the reflective sheet may include a plurality of cut-lines facing the plurality of diodes.

The display device further includes a connector coupled to the substrate and including a power source and a plurality of pins. The substrate may include: a power line connected to the power source and each of the plurality of local dimming blocks; and a plurality of lines opposite to the power line with respect to the plurality of light sources, wherein each of the plurality of lines may connect light sources of the each of the plurality of local dimming blocks, and may be connected to each of the plurality of pins.

The power line may be adjacent to distal ends of the legs and may be disposed along the legs; and some of the plurality of lines may be adjacent to the other long side of the body and may be disposed along the other long side.

The legs may include a mounting leg which is positioned at one end in a longitudinal direction of the body, and to which the connector is coupled, wherein a width of the mounting leg is a maximum width among widths of the legs.

The plurality of light sources may further include at least one row of light sources disposed between the first row of light sources and the second row of light sources.

A length of each of the legs may be smaller than a length of the body.

The substrate may further include a plurality of substrates which are spaced apart from each other in a longitudinal direction of the legs, wherein the display device may further include an extension board connecting the plurality of substrates, wherein the plurality of substrates may have a same shape.

The extension board may extend in the longitudinal direction of the legs, wherein the plurality of substrates may include: a plurality of first substrates coupled to a first long side of the extension board; and a plurality of second substrates coupled to a second long side of the extension board, wherein the plurality of first substrates and the plurality of second substrates may be point-symmetric with respect to a center point of the extension board or may be line-symmetric with respect to the extension board.

The display device may further include: an LED driver coupled to the frame; and a cable connecting the LED driver and the extension board.

The display device may further include: a plurality of lenses covering the plurality of light sources; and a reflective sheet positioned on the substate and having a plurality of holes at which the plurality of lenses are positioned.

The reflective sheet may cover the body, the legs, and grooves between the legs.

The display device according to the present disclosure has the following effects.

According to at least one of the embodiments of the present disclosure, there may be provided a display device in which substrate manufacturing costs may be reduced.

According to at least one of the embodiments of the present disclosure, there may be provided a structure capable of improving local dimming performance to improve image quality.

According to at least one of the embodiments of the present disclosure, there may be provided a structure capable of minimizing lifting of a reflective sheet on a substrate caused by diodes on the substrate, to improve image quality.

According to at least one of the embodiments of the present disclosure, there may be provided a structure capable of reducing the number of cables connecting an LED driver and a plurality of substrates.

According to at least one of the embodiments of the present disclosure, various examples of substrate shapes and arrangements may be provided.

Certain embodiments or other embodiments of the invention described above are not mutually exclusive or distinct from each other. Any or all elements of the embodiments of the invention described above may be combined or combined with each other in configuration or function.

For example, a configuration "A" described in one embodiment of the invention and the drawings and a configuration "B" described in another embodiment of the invention and the drawings may be combined with each other. Namely, although the combination between the configurations is not directly described, the combination is possible except in the case where it is described that the combination is impossible.

The foregoing embodiments are merely examples and are not to be considered as limiting the present disclosure

## Claims

1. A display device (1) comprising:
a display panel (10);
a frame (80) positioned behind the display panel;
a substrate (41, 45) positioned between the display panel and the frame, and coupled to the frame;
a plurality of light sources (51) positioned on the substrate; and
a connector (45Rz) coupled to the substrate (41, 45),
wherein the substrate (41) comprises:
an elongated body (421, 45L, 45R, 46L0, 46R0); and
legs (422, 46Ln, 46Rn) protruding from one side of the body and spaced apart from each other along the one side,
wherein the plurality of light sources (51) comprises:
a first row of light sources positioned on the legs; and
a second row of light sources positioned on the legs or the body, the second row being spaced apart from the first row,
wherein light sources (51) of the first and second rows of light sources are disposed parallel to the legs and two or more are grouped into a local dimming block (BL),
wherein the local dimming block (BL) includes at least one light source (51) from each of the first and second rows of light sources,
**characterized in that** the connector (45Rz) includes a power source (VL) and a plurality of pins (B1, B2, B3), **in that** the legs comprise a mounting leg (46L20) which is positioned at an end of the substrate, and to which the connector (46Rz, 46Lz) is coupled,
and **in that** a width (46tm) of the mounting leg is a maximum width among widths (46t, 46tm) of the legs.

2. The display device of claim 1, wherein the local dimming block (BL) is one of a plurality of local dimming blocks, and
the display device further comprises:
a plurality of diodes (Z) positioned on the substrate (41, 45) between the plurality of local dimming blocks.

3. The display device of claim 2, wherein the diode (Z) is configured to prevent electrostatic discharge.

4. The display device of claim 2 or 3, wherein the plurality of diodes (Z) are mounted on the body of the substrate.

5. The display device of any one of claims 2 to 4, further comprising a reflective sheet (60) positioned on the substrate (41, 45) and having holes at which the plurality of light sources are positioned,
wherein the reflective sheet (60) comprises a plurality of cut-lines corresponding to the plurality of diodes.

6. The display device of any one of claims 2 to 5,
wherein the substrate (45) further comprises:
a power line (Lv) connecting the power source and each of the plurality of local dimming blocks; and
a plurality of lines (Lf) positioned opposite to the power line with respect to the plurality of light sources,
wherein each of the plurality of lines (Lf) respectively connects the plurality of light sources of one of the local dimming blocks to one of the plurality of pins.

7. The display device of claim 6, wherein:
the power line (Lv) is disposed along a leg to be adjacent to a distal end of the leg; and
some of the plurality of lines (Lf) are disposed along another side of the body.

8. The display device of any one of claims 1 to 7, wherein the plurality of light sources further comprise at least one row of light sources disposed between the first row of light sources and the second row of light sources.

9. The display device of any one of claims 1 to 8, wherein a length of each of the legs is less than a length of the body.

10. The display device of any one of claims 1 to 9, wherein the substrate is one of a plurality of substrates which are spaced apart from each other in a longitudinal direction of the legs,
wherein the display device further comprises an extension board (59) connecting the plurality of substrates, and
wherein the plurality of substrates have a same shape.

11. The display device of claim 10, wherein the extension board (59) extends in the longitudinal direction of the legs,
wherein the plurality of substrates comprise:
a plurality of first substrates (46L) coupled to a first long side of the extension board; and
a plurality of second substrates (46R) coupled to a second long side of the extension board,
wherein the plurality of first substrates and the plurality of second substrates are point-symmetric with respect to a center point of the extension board or are line-symmetric with respect to the extension board.

12. The display device of claim 10 or 11, further comprising:
an LED driver (P2) coupled to the frame; and
a cable (Fi) connecting the LED driver and the extension board.

13. The display device of any one of claims 1 to 12, further comprising:
a plurality of lenses (53) covering the plurality of light sources; and
a reflective sheet (60) positioned on the substrate and having a plurality of holes (601) at which the plurality of lenses are positioned.

14. The display device of claim 13, wherein the reflective sheet covers the body, the legs, and grooves between the legs.

## Patentansprüche

1. Anzeigevorrichtung (1) umfassend:
ein Anzeigefeld (10);
einen hinter dem Anzeigefeld angeordneten Rahmen (80);
ein Substrat (41, 45), das zwischen dem Anzeigefeld und dem Rahmen positioniert und mit dem Rahmen verbunden ist;
eine Mehrzahl von Lichtquellen (51), die auf dem Substrat positioniert sind;
und
einen mit dem Substrat (41, 45) verbundenen Verbinder (45Rz),
wobei das Substrat (41) umfasst:
einen länglichen Körper (421, 45L, 45R, 46L0, 46R0); und
Schenkel (422, 46Ln, 46Rn), die von einer Seite des Körpers vorstehen und entlang dieser einen Seite voneinander beabstandet sind,
wobei die Mehrzahl von Lichtquellen (51) umfasst:
eine erste Reihe von Lichtquellen, die an den Schenkeln angeordnet sind; und
eine zweite Reihe von Lichtquellen, die an den Schenkeln oder dem Körper angeordnet sind, wobei die zweite Reihe von der ersten Reihe beabstandet ist,
wobei die Lichtquellen (51) der ersten und zweiten Reihe von Lichtquellen parallel zu den Schenkeln angeordnet sind und zwei oder mehr zu einem lokalen Dimmblock (BL) gruppiert sind,
wobei der lokale Dimmblock (BL) mindestens eine Lichtquelle (51) aus jeder der ersten und zweiten Reihe von Lichtquellen umfasst,
**dadurch gekennzeichnet, dass** der Verbinder (45Rz) eine Stromquelle (VL) und eine Mehrzahl von Stiften (B1, B2, B3) umfasst,
dass die Schenkel einen Befestigungsschenkel (46L20) umfassen, der an einem Ende des Substrats positioniert ist und mit dem der Verbinder (46Rz, 46Lz) verbunden ist,
und dass eine Breite (46tm) des Befestigungsschenkels die maximale Breite unter den Breiten (46t, 46tm) der Schenkel ist.

2. Anzeigevorrichtung nach Anspruch 1, wobei der lokale Dimmblock (BL) einer von einer Mehrzahl vom lokalen Dimmblöcken ist, und
die Anzeigevorrichtung ferner umfasst:
eine Mehrzahl von Dioden (Z), die auf dem Substrat (41, 45) zwischen der Mehrzahl von lokalen Dimmblöcken positioniert ist.

3. Anzeigevorrichtung nach Anspruch 2, wobei die Diode (Z) dazu eingerichtet ist, elektrostatische Entladungen zu verhindern.

4. Anzeigevorrichtung nach Anspruch 2 oder 3, wobei die Mehrzahl von Dioden (Z) auf dem Körper des Substrats angebracht ist.

5. Anzeigevorrichtung nach einem der Ansprüche 2 bis 4, die ferner eine reflektierende Folie (60) umfasst, die auf dem Substrat (41, 45) positioniert ist und Löcher aufweist, an denen die Mehrzahl von Lichtquellen positioniert ist,
wobei die reflektierende Folie (60) eine Mehrzahl von Schnittlinien umfasst, die der Mehrzahl von Dioden entspricht.

6. Anzeigevorrichtung nach einem der Ansprüche 2 bis 5,
wobei das Substrat (45) ferner umfasst:
eine Stromleitung (Lv), die die Stromquelle und jeden der mehreren lokalen Dimmblöcke verbindet; und
eine Mehrzahl von Leitungen (Lf), die in Bezug auf die Mehrzahl von Lichtquellen gegenüber der Stromleitung positioniert sind,
wobei jede der Mehrzahl von Leitungen (Lf) jeweils die Mehrzahl von Lichtquellen eines der lokalen Dimmblöcke mit einem der Mehrzahl von Pins verbindet.

7. Anzeigevorrichtung nach Anspruch 6, wobei:
die Stromleitung (Lv) entlang eines Schenkels angeordnet ist, um an ein distales Ende des Schenkels angrenzend zu sein; und
einige der Mehrzahl von Leitungen (Lf) entlang einer anderen Seite des Körpers angeordnet sind.

8. Anzeigevorrichtung nach einem der Ansprüche 1 bis 7, wobei die Mehrzahl von Lichtquellen ferner mindestens eine Reihe von Lichtquellen umfasst, die zwischen der ersten Reihe von Lichtquellen und der zweiten Reihe von Lichtquellen angeordnet ist.

9. Anzeigevorrichtung nach einem der Ansprüche 1 bis 8, wobei die Länge jedes der Schenkel geringer ist als die Länge des Körpers.

10. Anzeigevorrichtung nach einem der Ansprüche 1 bis 9, wobei das Substrat eines von einer Mehrzahl von Substraten ist, die in Längsrichtung der Schenkel voneinander beabstandet sind,
wobei die Anzeigevorrichtung ferner eine Erweiterungsplatine (59) umfasst, die die mehreren Substrate verbindet, und
wobei die Mehrzahl von Substraten die gleiche Form aufweist.

11. Anzeigevorrichtung nach Anspruch 10, wobei sich die Erweiterungsplatine (59) in Längsrichtung der Schenkel erstreckt,
wobei die Mehrzahl von Substraten umfasst:
eine Mehrzahl von ersten Substraten (46L), die mit einer ersten Längsseite der Erweiterungsplatine verbunden ist; und
eine Mehrzahl von zweiten Substraten (46R), die mit einer zweiten Längsseite der Erweiterungsplatine verbunden ist,
wobei die Mehrzahl von ersten Substraten und die Mehrzahl von zweiten Substraten punktsymmetrisch in Bezug auf einen Mittelpunkt der Erweiterungsplatine oder linien-symmetrisch in Bezug auf die Erweiterungsplatine sind.

12. Anzeigevorrichtung nach Anspruch 10 oder 11, die ferner umfasst:
einen mit dem Rahmen verbundenen LED-Treiber (P2); und
ein Kabel (Fi), das den LED-Treiber und die Erweiterungsplatine verbindet.

13. Anzeigevorrichtung nach einem der Ansprüche 1 bis 12, die ferner umfasst:
eine Mehrzahl von Linsen (53), die die Mehrzahl von Lichtquellen abdeckt; und
eine reflektierende Folie (60), die auf dem Substrat positioniert ist und eine Mehrzahl von Löchern (601) aufweist, an denen die Mehrzahl von Linsen positioniert ist.

14. Anzeigevorrichtung nach Anspruch 13, wobei die reflektierende Folie den Körper, die Schenkel und Nuten zwischen den Schenkeln abdeckt.

## Revendications

1. Dispositif d'affichage (1), comprenant:
un écran d'affichage (10);
un cadre (80) disposé derrière l'écran d'affichage;
un substrat (41, 45) qui est situé entre l'écran d'affichage et le cadre et accouplé au cadre;
une pluralité de sources lumineuses (51) positionnées sur le substrat; et
un connecteur (45Rz) couplé au substrat (41, 45),
dans lequel le substrat (41) comprend:
un corps allongé (421, 45L, 45R, 46L0, 46R0); et
des pieds (422, 46Ln, 46Rn) faisant saillie d'un côté du corps et espacés les uns des autres le long dudit côté,
dans lequel la pluralité de sources lumineuses (51) comprend:
une première rangée de sources lumineuses positionnées sur les pieds; et
une deuxième rangée de sources lumineuses positionnées sur les pieds ou le corps, la deuxième rangée étant espacée de la première rangée,
dans lequel les sources lumineuses (51) des première et deuxième rangées de sources lumineuses sont parallèles aux pieds et au moins deux sont regroupées dans un bloc de gradation local (BL),
dans lequel le bloc de gradation local (BL) comprend au moins une source lumineuse (51) provenant de chacune des première et deuxième rangées de sources lumineuses,
**caractérisé en ce que** le connecteur (45Rz) comprend une source d'alimentation (VL) et une pluralité de broches (B1, B2, B3), **en ce que** les pieds comprennent un pied de montage (46L20) qui est positionné à une extrémité du substrat et auquel est couplé le connecteur (46Rz, 46Lz),
et **en ce que** la largeur (46tm) du pied de montage est la largeur maximale parmi les largeurs (46t, 46tm) des pieds.

2. Dispositif d'affichage selon la revendication 1, dans lequel le bloc de gradation local (BL) fait partie d'une pluralité de blocs de gradation local, et
le dispositif d'affichage comprend en outre:
une pluralité de diodes (Z) positionnées sur le substrat (41, 45) entre la pluralité de blocs de gradation locaux.

3. Dispositif d'affichage selon la revendication 2, dans lequel la diode (Z) est conçue pour empêcher les décharges électrostatiques.

4. Dispositif d'affichage selon la revendication 2 ou 3, dans lequel la pluralité de diodes (Z) sont montées sur le corps du substrat.

5. Dispositif d'affichage (1) selon l'une quelconque des revendications 2 à 4, comprenant en outre une feuille réfléchissante (60) positionnée sur le substrat (41, 45) et comportant des trous au niveau desquels sont positionnées les multiples sources lumineuses,
dans lequel la feuille réfléchissante (60) comprend une pluralité de lignes de découpe correspondant à la pluralité de diodes.

6. Dispositif d'affichage selon l'une quelconque des revendications 2 à 5,
dans lequel le substrat (45) comprend en outre:
une ligne d'alimentation (Lv) connectant la source d'alimentation et chaque blocs parmi la pluralité des blocs de gradation locaux; et
une pluralité de lignes (Lf) positionnées à l'opposé de la ligne électrique par rapport à la pluralité de sources lumineuses
dans lequel chacune des multiples lignes (Lf) relie respectivement les multiples sources lumineuses de l'un des blocs de gradation locale à l'une des multiples broches.

7. Dispositif d'affichage selon la revendication 6, dans lequel:
la ligne d'alimentation (Lv) est disposée le long d'un pied de manière à être adjacente à une extrémité distale du pied; et
certaines parmi la pluralité de lignes (Lf) sont disposées le long d'un autre côté du corps.

8. Dispositif d'affichage selon l'une quelconque des revendications 1 à 7, dans lequel la pluralité de sources lumineuses comprend en outre au moins une rangée de sources lumineuses disposées entre la première rangée de sources lumineuses et la deuxième rangée de sources lumineuses.

9. Dispositif d'affichage selon l'une quelconque des revendications 1 à 8, dans lequel la longueur de chacun des pieds est inférieure à la longueur du corps.

10. Dispositif d'affichage selon l'une quelconque des revendications 1 à 9, dans lequel le substrat fait partie d'une pluralité de substrats qui sont espacés les uns des autres dans une direction longitudinale des pieds,
dans lequel le dispositif d'affichage comprend en outre une carte d'extension (59) reliant la pluralité de substrats, et
dans lequel la pluralité de substrats ont une même forme.

11. Dispositif d'affichage (59) selon la revendication 10, dans lequel la carte d'extension (59) s'étend dans la direction longitudinale des pieds,
dans lequel la pluralité de substrats comprend:
une pluralité de premiers substrats (46L) couplés à un premier côté long de la carte d'extension; et
une pluralité de deuxièmes substrats (46R) couplés à un deuxième côté long de la carte d'extension; et
dans lequel la pluralité de premiers substrats et la pluralité de deuxièmes substrats sont symétriques par rapport à un point central de la carte d'extension ou sont symétriques par rapport à la carte d'extension.

12. Dispositif d'affichage selon la revendication 10 ou 11, comprenant en outre:
un connecteur DEL (P2) couplé au cadre; et
un câble (Fi) connectant le circuit d'attaque de DEL et la carte d'extension.

13. Dispositif d'affichage selon l'une quelconque des revendications 1 à 12, comprenant en outre:
une pluralité de lentilles (53) recouvrant la pluralité des sources lumineuses;
et
une feuille réfléchissante (60) positionnée sur le substrat et comportant une pluralité de trous (601) au niveau desquels sont positionnées les lentilles.

14. Dispositif d'affichage selon la revendication 13, dans lequel la feuille réfléchissante recouvre le corps, les pieds et les rainures entre les pieds.
